# EUROPEAN PATENT APPLICATION

(11) **EP 4 333 311 A1**
(43) Date of publication of application: **06.03.2024**
(21) Application number: 22814832.6
(22) Date of filing: 29.03.2022
(51) Int. Cl.: H04B 1/04

(54) **POWER SUPPLY CIRCUIT, PROCESSING CIRCUIT, AND WIRELESS COMMUNICATION SYSTEM**

(30) Priority: 04.06.2021 CN 202110625120
(71) Applicant: Huawei Technologies Co., Ltd., Longgang Shenzhen, Guangdong 518129 (CN)
(72) Inventor: WU, Jianfeng, Shenzhen, Guangdong 518129 (CN); ZHANG, Yi, Shenzhen, Guangdong 518129 (CN); XUE, Pan, Shenzhen, Guangdong 518129 (CN); HU, Danting, Shenzhen, Guangdong 518129 (CN); CHANG, Hsianghui, Shenzhen, Guangdong 518129 (CN)
(74) Representative: Thun, Clemens
(86) International application number: PCT/CN2022/083788
(87) International publication number: WO 2022/252785

(57) **Abstract**

Embodiments of this application relate to the field of communication device technologies, and provide a power supply circuit, a processing circuit, and a wireless communication system, to improve transmit efficiency of a PA. The wireless communication system includes: a processing circuit, at least one linear amplification circuit, a switch amplification circuit, at least one first filter capacitor, and at least one power amplifier. An output end of the switch amplification circuit, an output end of the linear amplification circuit, and a power supply end of the power amplifier are coupled at a first node. The first filter capacitor is coupled to an input end of the linear amplification circuit or the output end of the linear amplification circuit.

## Description

This application claims priority to Chinese Patent Application No. 202110625120.0, filed with the China National Intellectual Property Administration on June 4, 2021 and entitled "POWER SUPPLY CIRCUIT, PROCESSING CIRCUIT, AND WIRELESS COMMUNICATION SYSTEM", which is incorporated herein by reference in its entirety.

### TECHNICAL FIELD

This application relates to the field of communication device technologies, and in particular, to a power supply circuit, a processing circuit, and a wireless communication system.

### BACKGROUND

As mobile wireless communication technologies gradually transition from being in a conventional voice communication-centric era to being in a fourth generation mobile communication technology (the 4^{th} generation mobile communication technology, 4G) era with a mobile broadband and a 5G era with a networked society, electronic devices with a mobile communication function or a wireless communication function have become increasingly popular and are used to provide a wireless communication service for users. As users have increasingly strong requirements on application of mobile wireless communication technologies, there are increasingly high requirements on communication rates, and users require access to wireless communication networks anytime and anywhere. These requirements have spurred the vigorous development of the mobile wireless communication technologies. Electronic devices need to support various communication modes and standards, from 4G long term evolution (long term evolution, LTE) to 5G new radio (new radio, NR), from early wireless fidelity (wireless fidelity, Wi-Fi) to today's Wi-Fi 6, and the like. A communication bandwidth becomes increasingly wide: from 4G LTE with a bandwidth of 1.4 MHz to 5G NR with a bandwidth of 100 MHz or even 200 MHz. In addition, in broadband Wi-Fi and millimeter-wave communication systems, a bandwidth of a signal is wider. These electronic devices usually perform corresponding processing on radio frequency (radio frequency, RF) signals. For example, before a radio frequency signal is transmitted, a power amplifier (power amplifier, PA) needs to be used to increase output power of the radio frequency signal (for example, to maintain sufficient energy per bit).

A service life of an electronic device is closely related to a battery capacity and system efficiency. Against a current background that a battery capacity cannot be expanded anymore while power consumption of another part in an electronic device becomes increasingly large, improving transmit efficiency of a radio frequency part, especially a radio frequency PA system that occupies a large proportion of power consumption, is highly important for prolonging a service life of a terminal.

### SUMMARY

Embodiments of this application provide a power supply circuit, a processing circuit, and a wireless communication system, to improve transmit efficiency of a PA.

To achieve the foregoing objective, the following technical solutions are used in this application.

According to a first aspect, a wireless communication system is provided. The wireless communication system includes: a processing circuit, at least one linear amplification circuit, a switch amplification circuit, at least one first filter capacitor, and at least one power amplifier. An output end of the switch amplification circuit, an output end of the linear amplification circuit, and a power supply end of the power amplifier are coupled at a first node. The first filter capacitor is coupled to an input end of the linear amplification circuit or the output end of the linear amplification circuit. The processing circuit is configured to: output a first radio frequency signal of a first transmit signal, and output a first envelope signal and a first drive signal that are of the first transmit signal. The first drive signal includes a switch signal of the switch amplification circuit or a second envelope signal. The switch signal of the switch amplification circuit is generated by the processing circuit based on the second envelope signal. The linear amplification circuit is configured to: receive the first envelope signal, and output a first power supply voltage to the first node. The switch amplification circuit is configured to: receive the first drive signal, and output a second power supply voltage to the first node. The power amplifier is configured to amplify the first radio frequency signal based on the first power supply voltage and the second power supply voltage. It should be noted that the first filter capacitor can filter out a low frequency part and a direct current part in the first envelope signal, or filter out a low frequency part and a direct current part in the first power supply voltage. The switch amplification circuit SA may include a control chip, for example, a drive chip, configured to convert the second envelope signal ET2_DAC41 to the switch signal of the switch amplification circuit SA. The switch signal of the switch amplification circuit may be a square wave signal, for example, a pulse width modulation (pulse width modulation) PWM square wave signal. When the switch amplification circuit SA includes the control chip, the processing circuit may directly send the second envelope signal ET2_DAC41 to the switch amplification circuit SA. When the switch amplification circuit SA does not include the control chip, the processing circuit may alternatively convert the second envelope signal ET2_DAC41 to the switch signal of the switch amplification circuit SA, and send the switch signal to the switch amplification circuit SA. In the foregoing solution, when the first filter capacitor C1 is disposed at the output end of the linear amplification circuit LA, as the low frequency part and the direct current part in the first power supply voltage are filtered out through filtering performed by the first filter capacitor C1, the first power supply voltage is an alternating current voltage that swings around 0 V In this way, because the first filter capacitor C1 exists, as the first filter capacitor C1 couples the output end of the linear amplification circuit LA to the output end of the switch amplification circuit SA, a voltage swing amplitude (that is, the first power supply voltage filtered by the first filter capacitor) may be provided between the second power supply voltage output by the SA and a power supply voltage at the power supply end of the power amplifier. In this way, a power supply voltage of the linear amplification circuit LA only needs to be equal to the voltage swing amplitude, but does not need to be equal to a voltage value of a highest crest in the first power supply voltage before the filtering of the first filter capacitor C1, so that the power supply voltage of the linear amplification circuit LA can be reduced. In addition, because a final power supply voltage of the power amplifier depends on superposition of an output voltage of the switch amplification circuit SA and a voltage swing amplitude output by the linear amplification circuit LA, this solution can support a peak voltage of an envelope signal higher than the power supply voltage of the linear amplification circuit LA. Therefore, with a lower power supply voltage of the LA, a larger power output of the power amplifier can be supported, so that transmit efficiency of the power amplifier is improved. In addition, when the first filter capacitor C1 is disposed at the input end of the LA, the first filter capacitor C1 may directly filter out the low frequency part and the direct current part in the first envelope signal ET1_DAC41. A waveform of the first envelope signal ET1_DAC41 is similar to that of the first power supply voltage. However, when the first envelope signal ET1_DAC41 is not amplified by the LA, an overall amplitude of the waveform of the first envelope signal ET1_DAC41 is smaller than that of the first power supply voltage. After the first filter capacitor C1 filters out the low frequency part and the direct current part in the first envelope signal ET1_DAC41, a voltage of the first envelope signal ET1_DAC41 is an alternating current voltage that swings around 0 V Because the first filter capacitor C1 is disposed at the input end of the LA, the low frequency part and the direct current part in the first envelope signal ET1_DAC41 are filtered out before the first envelope signal ET1_DAC41 is input to the LA. Therefore, the LA only needs to amplify a high frequency part in the first envelope signal ET1_DAC41. In addition, because the direct current part is removed, the power supply voltage of the LA can be effectively reduced. Therefore, with a lower power supply voltage of the LA, larger output power of the power amplifier can be supported, so that the transmit efficiency of the power amplifier PA is improved.

In a possible implementation, the first envelope signal includes an envelope signal of a high frequency part in the first transmit signal; and/or the second envelope signal includes an envelope signal of a low frequency part and a direct current part in the first transmit signal. Because the first filter capacitor C1 can isolate the direct current part and the low frequency part in the first power supply voltage, the LA with low efficiency only needs to amplify an envelope signal of a part of the first transmit signal BS1 (the envelope signal of the high frequency part, where for example, the first envelope signal ET1_DAC41 includes the envelope signal of the high frequency part in the first transmit signal) to generate the first power supply voltage, and an envelope signal of most of the first transmit signal (all the signal or the low frequency part and the direct current part, where for example, the second envelope signal ET_DAC42 includes all the first transmit signal or the envelope signal of the low frequency part and the direct current part in the first transmit signal) is amplified by the SA with high efficiency to generate the second power supply voltage. Finally, the first power supply voltage and the second power supply voltage are superposed at the first node a to obtain the power supply voltage of the power amplifier PA. For example, a highest frequency of the first envelope signal is greater than a highest frequency of the second envelope signal; and/or a lowest frequency of the first envelope signal is greater than a lowest frequency of the second envelope signal.

In a possible implementation, a second filter capacitor is further included, where the first filter capacitor is coupled to the output end of the linear amplification circuit, and the second filter capacitor is coupled to the input end of the linear amplification circuit. The first filter capacitor is configured to filter out the low frequency part and the direct current part in the first power supply voltage. The second filter capacitor is configured to filter out the low frequency part and the direct current part in the first envelope signal.

In a possible implementation, an analog high-pass filter is further included, where the first filter capacitor is coupled to the output end of the linear amplification circuit, and the analog high-pass filter is coupled to the input end of the linear amplification circuit. The first filter capacitor is configured to filter out the low frequency part and the direct current part in the first power supply voltage. The analog high-pass filter is configured to filter out the low frequency part and the direct current part in the first envelope signal.

In a possible implementation, the processing circuit is further configured to: perform shaping filtering on the first transmit signal to generate the first envelope signal; and perform shaping filtering on the first transmit signal to generate the second envelope signal. A function of performing shaping filtering on the first transmit signal BS1 is to enable the signal to better match a subsequent hardware channel (for example, to enable an amplitude and a phase of the first envelope signal ET1_DAC41 to better match a hardware capability of the LA, and to enable an amplitude and a phase of the second envelope signal ET2_DAC41 to better match a hardware capability of the SA).

In a possible implementation, the first filter capacitor is coupled to the output end of the linear amplification circuit. The processing circuit is configured to filter out the low frequency part and the direct current part in the first transmit signal to generate the first envelope signal. The first filter capacitor filters out the low frequency part and the direct current part in the first power supply voltage in analog domain. The processing circuit may filter out the low frequency part and the direct current part in the first transmit signal in digital domain by using a digital filtering function, to generate the first envelope signal.

In a possible implementation, the processing circuit is further configured to perform amplitude and/or phase compensation on the first transmit signal to generate the first envelope signal, or is further configured to perform amplitude and/or phase compensation on the first transmit signal to generate the second envelope signal. Transmission paths of the subsequent hardware channels of the first envelope signal ET1_DAC41 and the second envelope signal ET2_DAC41 are different, where the first envelope signal ET1_DAC41 is input to the LA, and the second envelope signal ET2_DAC41 is input to the SA. Therefore, a difference in hardware causes a phase difference between signals at the output ends of the LA and the SA and an amplitude loss. The processing circuit may further perform equalization processing on the first transmit signal BS1. For example, the processing circuit performs amplitude and/or phase compensation on the first transmit signal BS1 to generate the first envelope signal ET1_DAC41, or performs amplitude and/or phase compensation on the first transmit signal BS1 to generate the second envelope signal ET2_DAC41. A specific value of the amplitude and/or phase compensation depends on a hardware parameter of the LA or the SA. A value of the amplitude and/or phase compensation corresponding to the first envelope signal ET1_DAC41 may be determined by using the hardware parameter of the LA or by detecting a voltage at the output end of the LA. A value of the amplitude and/or phase compensation corresponding to the second envelope signal ET2_DAC41 may be determined by using the hardware parameter of the SA or by detecting a voltage at the output end of the SA.

In a possible implementation, in an embodiment of this application, the LA mainly processes the high frequency part in the first envelope signal ET_DAC41, and inductive reactance or capacitive reactance of a trace between the LA and the PA causes degradation of a high frequency signal. Therefore, it is necessary to shorten a trace length between the LA and the PA as much as possible, to reduce the inductive reactance or the capacitive reactance of the trace. A length of the trace between the linear amplification circuit and the power amplifier is less than a length of a trace between the switch amplification circuit and the power amplifier.

In a possible implementation, the linear amplification circuit and the power amplifier are packaged on a same package substrate, or the linear amplification circuit and the power amplifier are manufactured on a same die, to reduce the length of the trace between the switch amplification circuit SA and the power amplifier PA.

In a possible implementation, to better arrange the switch amplification circuit SA and the power amplifier PA to reduce the length of the trace between the switch amplification circuit SA and the power amplifier PA, the linear amplification circuit and the switch amplification circuit are manufactured on different dies.

In a possible implementation, the switch amplification circuit includes a multi-phase and/or multi-voltage switch amplification circuit. A multi-potential switch amplification circuit may use a plurality of different power supply voltages as input voltages of the switch amplification circuit, and the switch amplification circuit can separately output the second power supply voltage based on the plurality of different power supply voltages, to increase a range of a voltage value of the second power supply voltage. In addition, a multi-phase switch amplification circuit may provide, based on the power supply voltages input to the switch amplification circuit, a plurality of output voltages of different phases as the second power supply voltage, so that the SA is capable of outputting a second power supply voltage with a higher frequency when processing most of the first transmit signal (all the signal or the low frequency part and the direct current part).

In a possible implementation, at least one linear amplifier includes a first linear amplifier and a second linear amplifier. The at least one power amplifier includes a first power amplifier and a second power amplifier. The at least one first filter capacitor includes a third filter capacitor and a fourth filter capacitor. The output end of the switch amplification circuit, an output end of the first linear amplification circuit, and a power supply end of the first power amplifier are coupled at the first node. The third filter capacitor is coupled to an input end of the first linear amplification circuit or the output end of the first linear amplification circuit. The output end of the switch amplification circuit, an output end of the second linear amplification circuit, and a power supply end of the second power amplifier are coupled at a second node. The fourth filter capacitor is coupled to an input end of the second linear amplification circuit or the output end of the second linear amplification circuit. The first linear amplification circuit is configured to: receive the first envelope signal, and output the first power supply voltage to the first node. The second linear amplification circuit is configured to: receive the first envelope signal, and output a third power supply voltage to the second node. In a beamforming (beamforming) architecture or a multiple-input multiple-output (multiple-input multiple-output, MIMO) architecture, when the processing circuit transmits a same radio frequency signal on a plurality of channels, each channel corresponds to one power amplifier. In this case, to reduce hardware costs, a plurality of linear amplification circuits may share one switch amplification circuit, and a same radio frequency signal is simultaneously transmitted on different power amplifiers.

In a possible implementation, at least one linear amplifier includes a first linear amplifier and a second linear amplifier. The at least one power amplifier includes a first power amplifier and a second power amplifier. The at least one first filter capacitor includes a third filter capacitor and a fourth filter capacitor. The output end of the switch amplification circuit, an output end of the first linear amplification circuit, and a power supply end of the first power amplifier are coupled at the first node. The third filter capacitor is coupled to an input end of the first linear amplification circuit or the output end of the first linear amplification circuit. The output end of the switch amplification circuit, an output end of the second linear amplification circuit, and a power supply end of the second power amplifier are coupled at a second node. The fourth filter capacitor is coupled to an input end of the second linear amplification circuit or the output end of the second linear amplification circuit. When the first power amplifier is enabled by using an enable signal, the first linear amplification circuit is configured to: receive the first envelope signal, and output the first power supply voltage to the first node; or when the second power amplifier is enabled by using an enable signal, the second linear amplification circuit is configured to: receive the first envelope signal, and output a third power supply voltage to the second node. In a scenario of a plurality of transmit channels, for example, in an uplink multiple-input multiple-output (multiple-input multiple-output, MIMO) or uplink carrier aggregation (carrier aggregation, CA) scenario, the processing circuit may provide radio frequency signals of a plurality of channels, and the processing circuit may transmit a same radio frequency signal on some channels, and transmit different radio frequency signals on the other channels. Specifically, each channel corresponds to one power amplifier. The processing circuit may transmit a radio frequency signal of a corresponding channel on a power amplifier enabled by using the enable signal. In this way, different radio frequency signals may be transmitted on different power amplifiers in a time-sharing manner.

According to a second aspect, a power supply circuit is provided, including: at least one linear amplification circuit, a switch amplification circuit, and at least one first filter capacitor. An output end of the linear amplification circuit and an output end of the switch amplification circuit are coupled at a first node. A power supply end of a power amplifier is coupled at the first node. The first filter capacitor is coupled to an input end of the linear amplification circuit or the output end of the linear amplification circuit. The linear amplification circuit is configured to: receive a first envelope signal sent by a processing circuit, and output a first power supply voltage to the first node. The switch amplification circuit is configured to: receive a first drive signal sent by the processing circuit, and output a second power supply voltage to the first node. The first envelope signal and the first drive signal are generated by the processing circuit based on a first transmit signal. The first drive signal includes a switch signal of the switch amplification circuit or a second envelope signal. The switch signal of the switch amplification circuit is generated by the processing circuit based on the second envelope signal. The power amplifier amplifies, based on the first power supply voltage and the second power supply voltage, a first radio frequency signal generated by the processing circuit based on the first transmit signal. It should be noted that the first filter capacitor can filter out a low frequency part and a direct current part in the first envelope signal, or filter out a low frequency part and a direct current part in the first power supply voltage.

In a possible implementation, the first envelope signal includes an envelope signal of a high frequency part in the first transmit signal; and/or the second envelope signal includes an envelope signal of a low frequency part and a direct current part in the first transmit signal.

In a possible implementation, a second filter capacitor is further included, where the first filter capacitor is coupled to the output end of the linear amplification circuit, and the second filter capacitor is coupled to the input end of the linear amplification circuit. The first filter capacitor is configured to filter out the low frequency part and the direct current part in the first power supply voltage. The second filter capacitor is configured to filter out the low frequency part and the direct current part in the first envelope signal.

In a possible implementation, an analog high-pass filter is further included, where the first filter capacitor is coupled to the output end of the linear amplification circuit, and the analog high-pass filter is coupled to the input end of the linear amplification circuit. The first filter capacitor is configured to filter out the low frequency part and the direct current part in the first power supply voltage. The analog high-pass filter is configured to filter out the low frequency part and the direct current part in the first envelope signal.

In a possible implementation, a length of a trace between the linear amplification circuit and the power amplifier is less than a length of a trace between the switch amplification circuit and the power amplifier.

In a possible implementation, the linear amplification circuit and the power amplifier are packaged on a same package substrate, or the linear amplification circuit and the power amplifier are manufactured on a same die.

In a possible implementation, the linear amplification circuit and the switch amplification circuit are manufactured on different dies.

In a possible implementation, the switch amplification circuit includes a multi-phase and/or multi-voltage switch amplification circuit.

According to a third aspect, a power supply circuit is provided, including: at least one first analog low-pass filter, at least one second analog low-pass filter, at least one linear amplification circuit, a switch amplification circuit, and at least one first filter capacitor. An output end of the linear amplification circuit and an output end of the switch amplification circuit are coupled at a first node. A power supply end of a power amplifier is coupled at the first node. The first filter capacitor is coupled to an input end of the linear amplification circuit or the output end of the linear amplification circuit. The second analog low-pass filter is configured to filter out a high frequency part in a predetermined envelope signal received from a processing circuit, to generate a first envelope signal. The first analog low-pass filter is configured to perform delay adjustment on the predetermined envelope signal received from the processing circuit, to generate a second envelope signal. The linear amplification circuit is configured to: receive the first envelope signal, and output a first power supply voltage to the first node. The switch amplification circuit is configured to: receive the second envelope signal, and output a second power supply voltage to the first node. The predetermined envelope signal is generated by the processing circuit based on a first transmit signal. The power amplifier amplifies, based on the first power supply voltage and the second power supply voltage, a first radio frequency signal generated by the processing circuit based on the first transmit signal. It should be noted that the first filter capacitor can filter out a low frequency part and a direct current part in the first envelope signal, or filter out a low frequency part and a direct current part in the first power supply voltage.

In the wireless communication system provided in the first aspect, in addition to improving a power supply circuit in analog domain, in digital domain, the processing circuit further needs to be capable of separately generating, based on the first transmit signal BS1, the first envelope signal ET1_DAC41 provided to the LA and a first drive signal DR (which, for example, may be the second envelope signal ET2_DAC41) provided to the SA. In other words, the processing circuit 501 is also correspondingly improved. In the third aspect, in another solution, the processing circuit is not improved. That is, compared with the power supply circuit provided in the second aspect, for the predetermined envelope signal ET_DAC41 received from the processing circuit in the third aspect, one first analog low-pass filter AF 2 is added to an input end of the SA to perform low-pass filtering on an input predetermined envelop signal ET_DAC41 (filtering out a high frequency part in the predetermined envelope signal ET_DAC41) to extract a waveform input to the SA (that is, the second envelope signal ET2_DAC41). A bandwidth of the first analog low-pass filter AF 2 may be determined based on a switching frequency of the SA, for example, 1 MHz, 5 MHz, or 10 MHz. One second analog low-pass filter AF 3 is added to the input end of the SA to perform delay adjustment on the predetermined envelope signal ET_DAC41 to generate the first envelope signal ET1 DAC41, to implement delay difference adjustment of two signals on the SA and the LA and ensure phase alignment of voltages output by the SA and the LA. Therefore, the processing circuit does not need to be changed, and the predetermined envelope signal ET_DAC41 may be directly and compatibly used to supply power to the power amplifier PA. In addition, in the solution provided in the third aspect, a structure and a function of another part are similar to those in the solution provided in the first aspect. Details are not described herein again.

In a possible implementation, a second filter capacitor is further included, where the first filter capacitor is coupled to the output end of the linear amplification circuit, and the second filter capacitor is coupled to the input end of the linear amplification circuit. The first filter capacitor is configured to filter out the low frequency part and the direct current part in the first power supply voltage. The second filter capacitor is configured to filter out the low frequency part and the direct current part in the first envelope signal.

In a possible implementation, the second analog low-pass filter is further configured to filter out the low frequency part and the direct current part in the first envelope signal.

In a possible implementation, a length of a trace between the linear amplification circuit and the power amplifier is less than a length of a trace between the switch amplification circuit and the power amplifier.

In a possible implementation, the linear amplification circuit and the power amplifier are packaged on a same package substrate, or the linear amplification circuit and the power amplifier are manufactured on a same die.

In a possible implementation, the linear amplification circuit and the switch amplification circuit are manufactured on different dies.

In a possible implementation, the switch amplification circuit includes a multi-phase and/or multi-voltage switch amplification circuit.

According to a fourth aspect, a signal generation method is provided, including: outputting a first envelope signal of a first transmit signal, and outputting a first drive signal of the first transmit signal. The first drive signal includes a switch signal of a switch amplification circuit or a second envelope signal. The switch signal of the switch amplification circuit is generated by a processing circuit based on the second envelope signal. The first envelope signal includes an envelope signal of a high frequency part in the first transmit signal; and/or the second envelope signal includes an envelope signal of a low frequency part and a direct current part in the first transmit signal.

In a possible implementation, the outputting a first envelope signal of a first transmit signal includes: performing shaping filtering on the first transmit signal to generate the first envelope signal. The outputting a first drive signal of the first transmit signal includes: performing shaping filtering on the first transmit signal to generate the first drive signal.

In a possible implementation, the outputting a first envelope signal of a first transmit signal includes: filtering out the low frequency part and the direct current part in the first transmit signal to generate the first envelope signal.

In a possible implementation, the outputting a first envelope signal of a first transmit signal includes: performing amplitude and/or phase compensation on the first transmit signal to generate the first envelope signal.

The outputting a first drive signal of the first transmit signal includes: performing amplitude and/or phase compensation on the first transmit signal to generate the first drive signal.

According to a fifth aspect, a processing circuit is provided. The processing circuit is configured to implement the signal generation method according to the fourth aspect. The processing circuit may be user equipment, a chip (for example, a processor chip), or the like.

It should be understood that the technical solutions in the second aspect to the fifth aspect of this application are consistent with the technical solution in the first aspect of this application, and beneficial effects achieved in the aspects and the corresponding feasible implementations are similar. Details are not described again.

### BRIEF DESCRIPTION OF DRAWINGS

To describe technical solutions in embodiments of this application or in the background more clearly, the following describes the accompanying drawings used in embodiments of this application or in the background.
FIG. 1 is a top view of an electronic device according to an embodiment of this application;
FIG. 2 is a bottom view of an electronic device according to an embodiment of this application;
FIG. 3 is a schematic diagram of an internal structure of an electronic device with a rear cover opened according to an embodiment of this application;
FIG. 4 is a schematic diagram of a structure of a wireless communication system according to an embodiment of this application;
FIG. 5 is a schematic diagram of a structure of a processing circuit according to an embodiment of this application;
FIG. 6 is a schematic diagram of curves of a transmit signal and an envelope signal according to an embodiment of this application;
FIG. 7 is a schematic diagram of a structure of a wireless communication system according to another embodiment of this application;
FIG. 8 is a schematic diagram of a structure of a wireless communication system according to still another embodiment of this application;
FIG. 9 is a schematic diagram of a voltage at an output end of an LA according to an embodiment of this application;
FIG. 10 is a schematic diagram of a voltage at an output end of an SA according to an embodiment of this application;
FIG. 11 is a schematic diagram of a voltage of a first node according to an embodiment of this application;
FIG. 12 is a schematic diagram of a structure of a wireless communication system according to still yet another embodiment of this application;
FIG. 13 is a schematic diagram of a structure of a wireless communication system according to another embodiment of this application;
FIG. 14 is a schematic diagram of a structure of a wireless communication system according to still another embodiment of this application;
FIG. 15 is a schematic diagram of a structure of a wireless communication system according to still yet another embodiment of this application;
FIG. 16 is a schematic diagram of a structure of a wireless communication system according to another embodiment of this application;
FIG. 17 is a schematic diagram of a structure of a wireless communication system according to still another embodiment of this application;
FIG. 18 is a schematic diagram of a package structure of a wireless communication system according to an embodiment of this application;
FIG. 19 is a schematic diagram of a partial structure of a wireless communication system according to an embodiment of this application;
FIG. 20 is a schematic diagram of a partial structure of a wireless communication system according to another embodiment of this application;
FIG. 21 is a schematic diagram of a partial structure of a wireless communication system according to still another embodiment of this application;
FIG. 22 is a schematic diagram of a structure of an SA according to an embodiment of this application;
FIG. 23 is a schematic diagram of a structure of an SA according to another embodiment of this application;
FIG. 24 is a schematic diagram of a structure of an SA according to still another embodiment of this application; and
FIG. 25 is a schematic diagram of a structure of an SA according to still yet another embodiment of this application.

### DESCRIPTION OF EMBODIMENTS

The following describes embodiments of this application with reference to the accompanying drawings in embodiments of this application. In the following descriptions, refer to the accompanying drawings that form a part of this application and show, in an illustrative manner, specific aspects of embodiments of this application or specific aspects in which embodiments of this application may be used. It should be understood that embodiments of this application may be used in another aspect, and may include structural or logical changes that are not depicted in the accompanying drawings. For example, it should be understood that disclosed content with reference to the described method may also be applied to a corresponding device or system configured to perform the method, and vice versa. For example, if one or more specific method steps are described, a corresponding device may include one or more units such as a functional unit for performing the described one or more method steps (for example, one unit for performing the one or more steps; or a plurality of units, each of which performs one or more of a plurality of steps), even if such one or more units are not explicitly described or illustrated in the accompanying drawings. In addition, for example, if a specific apparatus is described based on one or more units such as a functional unit, a corresponding method may include one step for implementing functionality of one or more units (for example, one step for implementing functionality of one or more units; or a plurality of steps, each of which performs functionality of one or more units in a plurality of units), even if such one or more of steps are not explicitly described or illustrated in the accompanying drawings. Further, it should be understood that, unless otherwise specified, features of various example embodiments and/or aspects described in this specification may be combined with each other.

In this application, unless otherwise clearly specified and limited, the term "coupling" may be a manner of implementing an electrical connection for signal transmission, and the term "coupling" may be a direct electrical connection, or may be an indirect electrical connection through an intermediate medium.

A low frequency part in embodiments of this application is also referred to as a low frequency component, and a high frequency part is also referred to as a high frequency component. In embodiments of this application, the low frequency part and the high frequency part are merely relative concepts. In embodiments of this application, a signal includes a low frequency part, a high frequency part, and a direct current part. There is an intersection or no intersection between the low frequency part and the high frequency part. The low frequency part includes a part of the signal whose frequency is below a reference frequency threshold, and the high frequency component includes a part of the signal whose frequency is higher than a reference frequency threshold, where the reference frequency threshold of the low frequency part may be the same as or different from the reference frequency threshold of the high frequency part.

A linear amplification circuit/linear amplifier (linear amplifier, LA) is also referred to as a linear power amplifier. The linear amplification circuit LA is an amplifier whose amplitude of an output signal is directly proportional to an amplitude of an input signal. A typical linear amplification circuit LA includes: a class B power amplifier (class B) and a class AB power amplifier (class AB).

A switch amplification circuit/switch amplifier (switch amplifier, SA) is also referred to as a switch power amplifier or a switch-type power amplifier. Compared with the LA, efficiency of the SA is high. Generally, the efficiency of the SA may reach at least 90%, and may even reach 100% in an ideal state. Atypical switch amplifier includes a class D power amplifier.

An embodiment of this application provides a wireless communication system. The wireless communication system may be applied to an electronic device such as a mobile phone, a tablet computer, a personal computer (personal computer, PC), a personal digital assistant (personal digital assistant, PDA), a smartwatch, a netbook, a wearable electronic device, an augmented reality (augmented reality, AR) device, a virtual reality (virtual reality, VR) device, a vehicle-mounted device, a smart automobile, a smart speaker, a robot, or smart glasses.

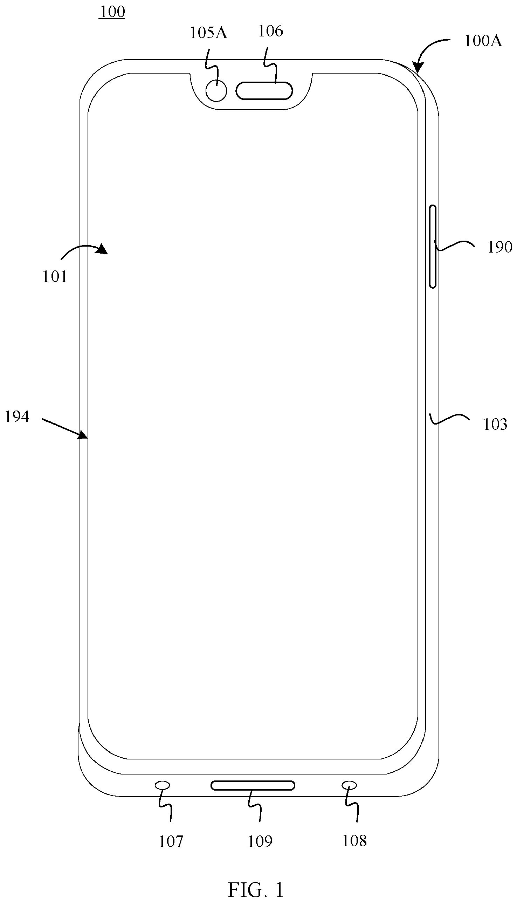

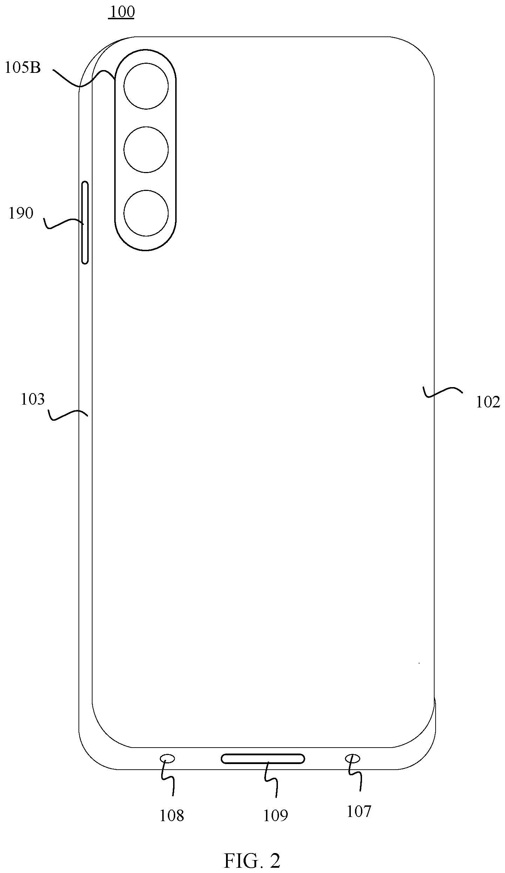

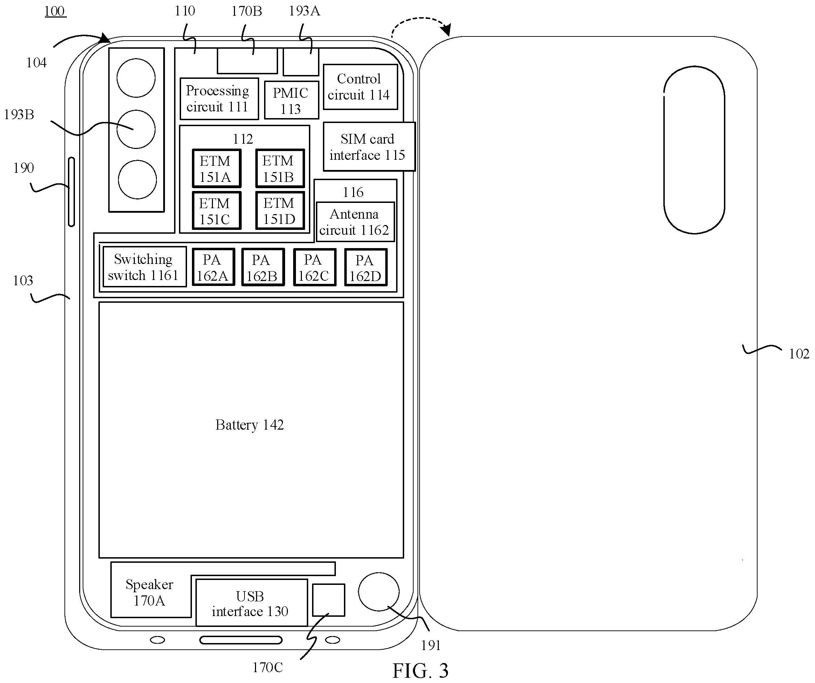

FIG. 1 to FIG. 3 are schematic diagrams of a structure of an electronic device 100 according to an embodiment of this application. FIG. 1 is a top view of the electronic device 100 according to an embodiment of this application. FIG. 2 is a bottom view of the electronic device 100 according to an embodiment of this application. FIG. 3 is a schematic diagram of an internal structure of the electronic device 100 with a rear cover opened according to an embodiment of this application. FIG. 3 shows a specific configuration of various internal components of the electronic device. A dashed arrow in FIG. 3 indicates a direction in which the rear cover is opened. It can be understood that the structure of the electronic device 100 shown in FIG. 1 to FIG. 3 does not constitute a specific limitation on the electronic device 100 in this embodiment of this application. In some possible implementations, compared with that shown in FIG. 1 to FIG. 3, the electronic device 100 may alternatively include more or fewer components, a combination of some components, some split components, an arrangement of different components, or the like. This is not specifically limited in this embodiment of this application.

Refer to FIG. 1 and FIG. 2. The electronic device 100 may include a housing 100A. The housing 100A may include a front cover 101, a rear cover 102, and a frame 103. The front cover 101 and the rear cover 102 are disposed opposite to each other. The frame 103 surrounds the front cover 101 and the rear cover 102, and couples the front cover 101 to the rear cover 102.

The front cover 101 may be a glass cover, and a display 194 is disposed below the front cover 101. A structure corresponding to an input/output component may be disposed on a periphery of the housing 100A. For example, an opening 105A corresponding to a front-facing camera and/or an opening 106 corresponding to a receiver are disposed at the top of the front cover 101. A button 190 may further be disposed on one side of the frame 103. An opening 107 corresponding to a microphone, an opening 108 corresponding to a speaker, and an opening 109 corresponding to a USB interface are disposed at the bottom of the frame 103. An opening 105B corresponding to a rear-facing camera may further be disposed at the top of the rear cover 102. Certainly, there may be another structure disposed around the housing 100A. This is not specifically limited in this embodiment of this application.

Further, a cavity may be formed inside the housing 100A. The foregoing internal components may be accommodated in the cavity. For example, as shown in FIG. 3, the internal components may be accommodated in a cavity 104. During actual application, the internal components may include components such as a printed circuit board (printed circuit board, PCB) 110, a battery 142 configured to supply power to the internal components, a speaker 170A configured to convert an electrical audio signal to a sound signal, a receiver 170B configured to convert an electrical audio signal to a sound signal, a microphone 170C configured to convert a sound signal to an electrical audio signal, a USB interface 130, a camera 193A, a camera 193B, and a motor 191 configured to generate a vibration prompt. A processing circuit 111, a power supply circuit 112, a power management integrated circuit (power management integrated circuit, PMIC) 113, a control circuit 114, a SIM card interface 115, a front-end module (front-end module, FEM) circuit 116, and the like may be disposed on the printed circuit board 110. The FEM circuit 116 may include at least one power amplifier (PA), a switching switch 1161, an antenna circuit 1162, and the like. The power supply circuit 112 may include at least one envelope tracking modulator (envelope tracking modulator, ETM). The PMIC 113 provides a battery voltage for the at least one envelope tracking modulator. The at least one envelope tracking modulator may be configured to supply power to the at least one power amplifier. One envelope tracking modulator is configured for one power amplifier.

It should be noted that a filter, a low noise amplifier, an audio codec, an internal memory, a sensor, an inductor, a capacitor, and the like may further be disposed on the PCB 110. Herein, to clearly display this embodiment of this application, the filter, the low noise amplifier, the audio codec, the internal memory, the sensor, the inductor, and the capacitor are not shown in FIG. 3. Further, because components on the PCB 110 are closely arranged, to place all components in limited space, a manner of arranging the components on the PCB 110 is not specifically limited in this embodiment of this application. For example, the internal components may be disposed on one side (for example, one side facing the rear cover 102) of the PCB 110; or the internal components may be disposed on two sides (for example, respectively located on one side facing the rear cover 102 and one side facing the front cover 101) of the PCB 110. This is not specifically limited in this embodiment of this application.

For example, refer to FIG. 3. The at least one power amplifier may include: a power amplifier PA 162A, a power amplifier PA 162B, a power amplifier PA 162C, and a power amplifier PA 162D. Different power amplifiers may support a same frequency band or different frequency bands, and are configured to amplify radio frequency signals in a same frequency band or different frequency bands and in a same bandwidth range or different bandwidth ranges. It is assumed that the power amplifier PA 162Amay be configured to amplify a radio frequency signal in a bandwidth range (wideband) A, the power amplifier PA 162B may be configured to amplify a radio frequency signal in a bandwidth range B, the power amplifier PA 162C may be configured to amplify a radio frequency signal in a bandwidth range C, and the power amplifier PA 162D may be configured to amplify a radio frequency signal in a bandwidth range D. One or more of A, B, C, and D may be the same, or may be different. Correspondingly, the at least one envelope tracking modulator may include: an envelope tracking modulator ETM 151A, an envelope tracking modulator ETM 151B, an envelope tracking modulator ETM 151C, and an envelope tracking modulator ETM 151D. Different envelope tracking modulators may support a same bandwidth range or different bandwidth ranges. The envelope tracking modulator ETM 151A may supply power to the power amplifier PA 162A, the envelope tracking modulator ETM 151B may supply power to the power amplifier PA 162B, the envelope tracking modulator ETM 151C may supply power to the power amplifier PA 162C, and the envelope tracking modulator ETM 151D may supply power to the power amplifier PA 162D.

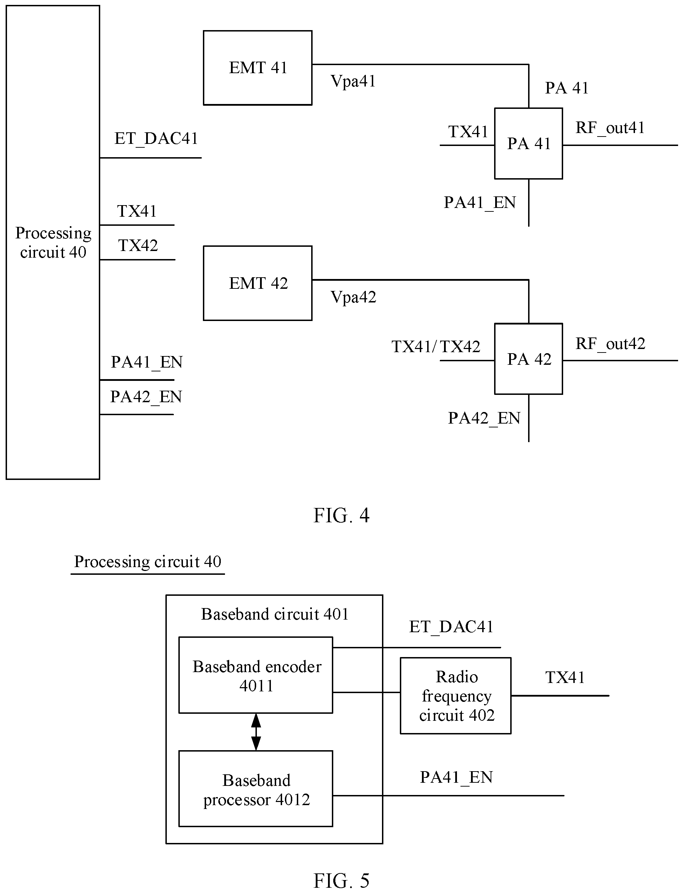

Specifically, FIG. 4 is a schematic diagram of a structure of a wireless communication system according to an embodiment of this application. The wireless communication system may be used in the electronic device 100 shown in FIG. 1 to FIG. 3, to transmit a radio frequency signal. The wireless communication system may include a processing circuit 40, a power amplifier PA 41, a power amplifier PA 42, an envelope tracking modulator ETM 41, and an envelope tracking modulator ETM 42. Herein, the processing circuit 40 may be a part or all of the processing circuit 111 shown in FIG. 1 to FIG. 3. When the wireless communication system transmits the radio frequency signal, the processing circuit 40 may generate a first radio frequency signal TX41 based on to-be-sent data on one channel. For example, a baseband circuit in the processing circuit 40 generates a baseband signal (baseband signal, BS), for example, an in-phase quadrature (In-phase quadrature, IQ) signal, and inputs the baseband signal to a radio frequency circuit in the processing circuit 40. The radio frequency circuit modulates the baseband signal BS to generate the first radio frequency signal TX41. The first radio frequency signal TX41 is a radio frequency signal.

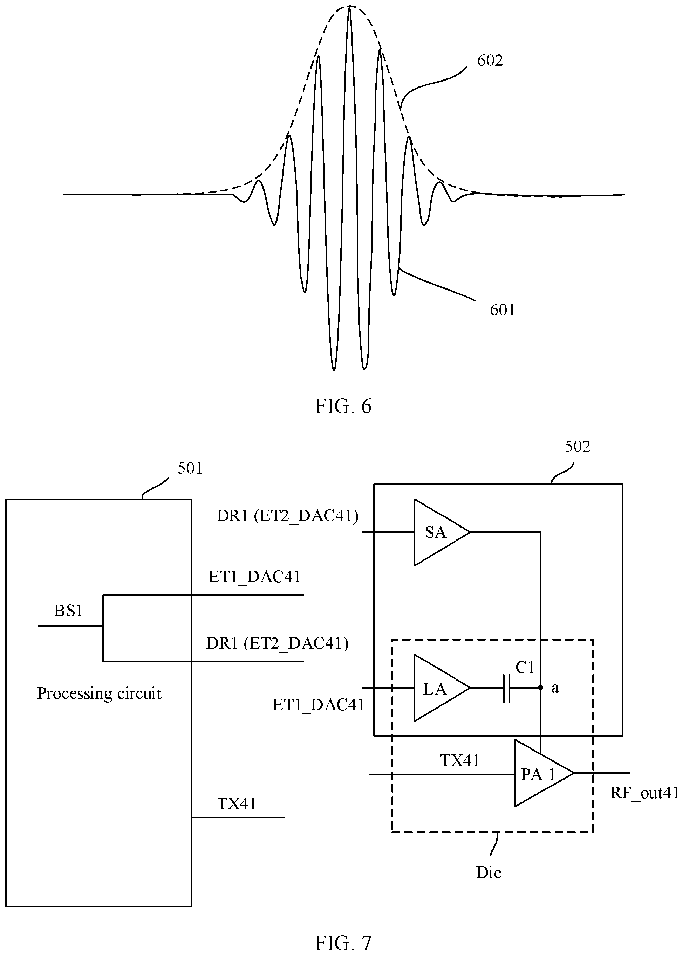

Further, the processing circuit 40 may further provide a predetermined envelope signal ET_DAC41 to the envelope tracking modulator ETM 41 and the envelope tracking modulator ETM 42. FIG. 6 is a schematic diagram of the first radio frequency signal TX41 and the predetermined envelope signal ET_DAC41 according to an embodiment of this application. Refer to FIG. 6. A curve 601 represents a waveform of one radio frequency signal (for example, the first radio frequency signal TX41). A curve 602 is a curve formed by connecting highest amplitude points of the first radio frequency signal TX41 at different frequencies. The curve 602 may be referred to as an envelope signal (the predetermined envelope signal ET_DAC41) of the curve 601. An amplitude of a first envelope signal ET _DAC41 changes with an amplitude of the first radio frequency signal TX41.

The envelope tracking modulator ETM 41 is configured to supply power to the power amplifier PA 41 based on the predetermined envelope signal ET_DAC41. When the first radio frequency signal TX41 is in a bandwidth range A (for example, when the first radio frequency signal TX41 is in a bandwidth range of a frequency band of a 4G network), the power amplifier PA 41 is configured to: amplify output power of the first radio frequency signal TX41 based on a power supply voltage Vpa41 output by the envelope tracking modulator ETM 41, and output a first amplified output signal RF_out41.

The envelope tracking modulator ETM 42 is configured to supply power to the power amplifier PA 42 based on the predetermined envelope signal ET_DAC41. When the first radio frequency signal TX41 is in a bandwidth range B (for example, when the first radio frequency signal TX41 is in a bandwidth range specified by medium frequency bands n41, n77, n78, and n79 of a 5G network), the power amplifier PA 42 is configured to: amplify the output power of the first radio frequency signal TX41 based on a power supply voltage Vpa42 output by the envelope tracking modulator ETM 42, and output a second amplified output signal RF_out42. FIG. 4 shows only two ETMs. It can be understood that more or fewer ETMs may be included.

In some possible implementations, refer to FIG. 4. Because the wireless communication system may support dual-channel or multi-channel transmission in technologies such as multiple-input multiple-output (multiple-input multiple-output, MIMO), the wireless communication system may provide radio frequency signals of two or more channels: the TX41 and the TX42. When radio frequency signals of two channels are in different bandwidth ranges, system indicators of the wireless communication system are greatly different, and requirements on the envelope tracking modulator are also greatly different. Therefore, for different radio frequency signals and different bandwidth ranges, a plurality of envelope tracking modulators need to be disposed. For example, refer to FIG. 4. The envelope tracking modulator ETM 41 is correspondingly disposed for the first radio frequency signal TX41, and the envelope tracking modulator ETM 42 is correspondingly disposed for the second radio frequency signal TX2. The foregoing wireless communication system needs two envelope tracking modulators in total to respectively supply power, in different bandwidth ranges, to power amplifiers in different operating frequency bands.

In some possible implementations, the processing circuit 111 shown in FIG. 3 may include at least one baseband circuit and at least one radio frequency (RF) circuit. One baseband circuit may correspond to one radio frequency circuit. The baseband circuit and the radio frequency circuit corresponding to the baseband circuit may modulate a signal based on one or more communication technologies. For example, a first baseband circuit and a first radio frequency circuit may modulate a signal based on a 5G technology, a second baseband circuit and a second radio frequency circuit may modulate a signal based on a 4G technology, a third baseband circuit and a third radio frequency circuit may modulate a signal based on a Wi-Fi technology, and a fourth baseband circuit and a fourth radio frequency circuit may modulate a signal based on a Bluetooth technology. Alternatively, the first baseband circuit and the first radio frequency circuit may modulate a signal based on both the 4G technology and the 5G technology, and the second baseband circuit and the second radio frequency circuit may modulate a signal based on the Wi-Fi technology. Certainly, in some possible implementations, one baseband circuit may alternatively correspond to a plurality of radio frequency circuits, to improve integration. During actual application, the foregoing radio frequency circuit may be a radio frequency integrated circuit (radio frequency integrated circuit, RFIC).

During actual application, FIG. 5 is a schematic diagram of a structure of the processing circuit 40 according to an embodiment of this application. Refer to FIG. 5. The processing circuit 40 may include: a baseband circuit 401 and a radio frequency circuit 402. The baseband circuit 401 may include a baseband encoder 4011 and a baseband processor 4012. The baseband encoder 4011 encodes a received signal source, and outputs a baseband signal Bs (for example, a first transmit signal in an embodiment of this application) after encoding. The baseband encoder 4011 may further determine an envelope of the baseband signal Bs by, for example, calculating an amplitude of the baseband signal Bs and averaging a plurality of amplitudes. The baseband encoder 1011 may output an envelope signal ET_DAC (for example, a predetermined envelope signal ET _DAC41) including envelope information of the baseband signal Bs. The baseband processor 4012 may be a central processing unit (central processing unit, CPU), a microprocessor (microcontroller unit, MCU), or the like. The baseband processor 4012 may have processing and control functions, to generate an enable signal of a power amplifier, for example, an enable signal PA 41_EN of the power amplifier PA 41 and/or an enable signal PA 42_EN of the power amplifier PA 42. The radio frequency circuit 402 is configured to receive the baseband signal Bs from the baseband circuit 401, and process the baseband signal Bs to generate the first radio frequency signal TX41. For example, the radio frequency circuit 402 may perform processing such as conversion to analog, filtering, and up-conversion, to obtain the first radio frequency signal TX41 of a radio frequency. In some possible implementations, the predetermined envelope signal ET_DAC41 may alternatively be generated by the radio frequency circuit 402. Specifically, in an embodiment of this application, the baseband encoder 4011 or the radio frequency circuit 402 may further divide the baseband signal Bs into at least two signals, and may further perform processing such as digital filtering, shaping filtering, and amplitude and/or phase compensation (phase alignment) on any baseband signal Bs.

It should be noted that the foregoing one or more communication technologies can be understood as one or more mobile communication technologies, for example, a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), an emerging wireless communication technology (which may also be referred to as a fifth generation mobile communication technology, English: 5^{th} generation mobile networks or 5^{th} generation wireless systems, 5^{th}-Generation, or 5^{th}-Generation New Radio, and may be briefly referred to as 5G, a 5G technology, or 5GNR), and the like. A wireless communication technology may include a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, or the like.

Certainly, the processing circuit 111 may further include an application circuit. The application circuit may include one or more processors. For example, the application circuit may include a circuit such as, but not limited to, one or more single-core or multi-core processors. The (one or more) processors may include a combination of a general-purpose processor and a dedicated processor (for example, a graphics processing unit or an application processor), such as an application processor (application processor, AP), a modem processor, a graphics processing unit (graphics processing unit, GPU), an image signal processor (image signal processor, ISP), a neural-network processing unit (neural-network processing unit, NPU), a video codec, or a digital signal processor (digital signal processor, DSP). These processors may be coupled to a memory/storage or may include a memory/storage, and may be configured to execute instructions stored in the memory/storage to enable various applications or systems to be run on an electronic device 100.

In some possible implementations, the baseband circuit and the radio frequency circuit may be integrated, in an independent device, with another component in the processing circuit 111. Alternatively, the baseband circuit and the radio frequency circuit may be independent devices independent of the processing circuit 111. In some embodiments, one baseband circuit and one radio frequency circuit may be integrated in one independent device, and the independent device and the processing circuit 111 are separately disposed.

During specific application, the foregoing baseband circuit may include a circuit such as, but not limited to, one core processor. The baseband circuit (having multiple cores or more single cores) may include one or more baseband processors or control logic, and these processors or the control logic generates a baseband signal used for a transmit path of the radio frequency circuit. The baseband circuit may be coupled to an application circuit interface, to generate and process the baseband signal and control an operation of the radio frequency circuit.

In some possible implementations, the baseband circuit may include a third generation (3G) baseband processor, a fourth generation (4G) baseband processor, a fifth generation (5G) baseband processor, or another future baseband processor. The baseband circuit may process various radio control functions used for communication between the radio frequency circuit and one or more wireless networks.

In some other implementations, some or all functions of the baseband processor may be included in a module stored in the memory, and may be executed by a central processing unit (CPU). The radio control functions may include but is not limited to signal modulation/demodulation, encoding/decoding, radio frequency shifting, and the like.

During actual application, a modulation/demodulation function of the baseband circuit may include a function such as fast Fourier transform (fast Fourier transform, FFT), precoding, or constellation mapping/demapping. An encoding/decoding function of the baseband circuit may include a function such as convolution, tail-biting convolution, turbo, Viterbi, or low-density parity check (low-density parity check, LDPC) encoder/decoder. Certainly, implementations of the foregoing modulation/demodulation and encoder/decoder functions are not limited to these examples, and another suitable function may be included in another implementation.

In some implementations, the baseband circuit may further include one or more audio digital signal processors (digital signal processors, DSPs). The (one or more) audio DSPs may include an element for compression/decompression and echo cancellation, and may include another suitable processing element in another implementation.

In some implementations, components in the baseband circuit may be suitably combined in a single chip machine or a single chipset, or may be arranged on a same PCB. In addition, some or all components of the baseband circuit and the application circuit may be disposed on a system on chip (system on chip, SOC).

With development of the wireless communication technology, the baseband circuit may support one or more wireless communication technologies. In this case, the baseband circuit may support communication with an evolved universal terrestrial radio access network (evolved universal mobile telecommunication system terrestrial radio access network, E-UTRAN) or another wireless metropolitan area network (wireless metropolitan area network, WMAN), a wireless local area network (wireless local area network, WLAN), a wireless personal area network (wireless personal area network communication technologies, WPAN), or the like. The baseband circuit configured to support a plurality of wireless communication protocols may be referred to as a multi-mode baseband circuit.

It should be noted that because functions of the electronic device 100 are increasingly complete, a quantity of internal components of the electronic device 100 is also increasing. In this case, a cavity 104 may further include a sensor, for example, a pressure sensor, a gyroscope sensor, a barometric pressure sensor, a magnetic sensor, an acceleration sensor, a distance sensor, an optical proximity sensor, a fingerprint sensor, a temperature sensor, a touch sensor, an ambient light sensor, or a bone conduction sensor.

With development of communication technologies, a fifth generation mobile communication system (5G) has been widely considered as a next generation wireless communication technology that surpasses a current third generation (3G) communication technology (for example, WCDMA) and fourth generation (4G) communication technology (for example, long term evolution LTE). Compared with wireless communication systems of a 3G communication technology and a 4G communication technology, a 5G wireless communication system provides a higher data rate and a lower latency. In addition, a radio frequency signal of a 5G communication system covers a wider bandwidth range, including a 5G low frequency band (band) (for example, lower than 1 GHz), a 5G medium frequency band (for example, 1 GHz to 6 GHz), and a 5G high frequency band (for example, higher than 24 GHz). Different communication technologies specify different frequency bands and different maximum bandwidths. For example, a maximum bandwidth specified in a 2G standard is 200 kHz (an uplink bandwidth is less than 100 kHz, and the uplink bandwidth is an uplink bandwidth allocated by an operator), a maximum bandwidth specified in a 3G standard is 10 MHz (an uplink bandwidth is less than 2 kHz), a maximum bandwidth specified in a 4G standard may reach 100 MHz (an uplink bandwidth may reach 20 MHz), and a maximum bandwidth specified in a 5G standard may reach 1 GHz to 2 GHz (an uplink bandwidth may reach at least 100 MHz). It is common that a same operator can simultaneously operate communication systems of a plurality of different standards. A plurality of different communication technologies can be simultaneously applied to a same electronic device having a mobile communication function and/or a wireless communication function. In addition, in a same communication technology, bandwidth ranges of different frequency bands can differ greatly. These electronic devices usually perform corresponding processing on radio frequency (radio frequency, RF) signals. For example, before the radio frequency signal is transmitted, a power amplifier (power amplifier, PA) needs to be used to increase output power of the radio frequency signal (for example, maintain sufficient energy per bit).

A service life of an electronic device is closely related to a battery capacity and system efficiency. Against a current background that the battery capacity cannot be expanded anymore while power consumption of another part in the electronic device becomes increasingly large, improving transmit efficiency of a radio frequency part, especially a radio frequency PA system that occupies a large proportion of power consumption, is highly important for prolonging a service life of a terminal.

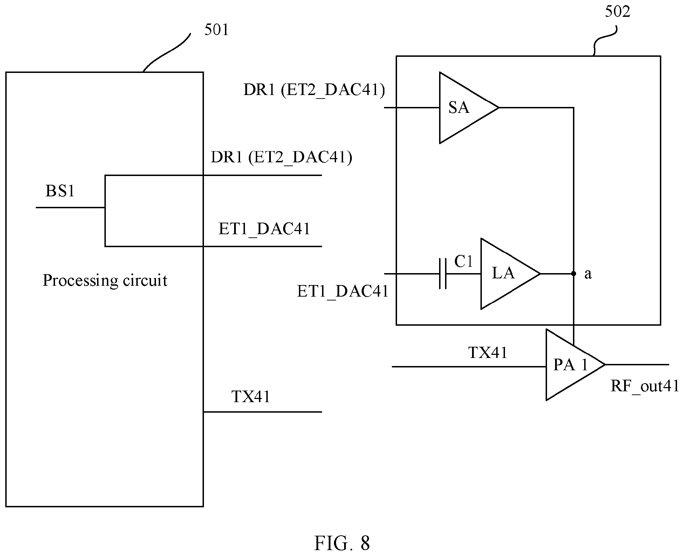

To resolve the foregoing problem, an embodiment of this application provides a wireless communication system, including: a processing circuit 501, at least one linear amplification circuit LA, a switch amplification circuit SA, at least one first filter capacitor C1, and at least one power amplifier PA 1. With reference to FIG. 7 or FIG. 8, an example in which one linear amplification circuit LA, one first filter capacitor C1, and one power amplifier PA 1 are included is used for description. An output end of the switch amplification circuit SA, an output end of the linear amplification circuit LA, and a power supply end of the power amplifier PA 1 are coupled at a first node a. The first filter capacitor C1 is coupled to an input end of the linear amplification circuit LA (as shown in FIG. 8) or the output end of the linear amplification circuit LA (as shown in FIG. 7). The linear amplification circuit LA, the switch amplification circuit SA, and the first filter capacitor C1 form an EMT 502 that is used as a power supply circuit of the PA 1.

Specifically, the processing circuit 501 is configured to: output a first radio frequency signal TX41 of a first transmit signal BS1, and output a first envelope signal ET1_DAC41 and a first drive signal DR1 of the first transmit signal BS1. The first drive signal DR1 includes a switch signal of the switch amplification circuit or a second envelope signal ET2 _DAC41. The switch signal of the switch amplification circuit is generated by the processing circuit 501 based on the second envelope signal ET2_DAC41. The linear amplification circuit LA is configured to: receive the first envelope signal ET1_DAC41, and output a first power supply voltage to the first node a. The switch amplification circuit SA is configured to: receive the first drive signal DR1, and output a second power supply voltage to the first node a. The power amplifier PA 1 is configured to amplify the first radio frequency signal TX41 based on the first power supply voltage and the second power supply voltage to generate a first amplified output signal RF_out41.

It should be noted that the first filter capacitor C1 can filter out a low frequency part and a direct current part in the first envelope signal ET1_DAC41, or filter out a low frequency part and a direct current part in the first power supply voltage. In addition, as shown in FIG. 7 and FIG. 8, the first drive signal DR1 may be the switch signal of the switch amplification circuit, or the second envelope signal ET2_DAC41. Specifically, the switch amplification circuit SA may include a control chip, for example, a drive chip, configured to convert the second envelope signal ET2_DAC41 to the switch signal of the switch amplification circuit SA. The switch signal of the switch amplification circuit may be a square wave signal, for example, a PWM square wave signal. When the SA includes the control chip, the processing circuit 501 may directly send the second envelope signal ET2_DAC41 to the SA. When the SA does not include the control chip, the processing circuit 501 may alternatively convert the second envelope signal ET2_DAC41 to the switch signal of the switch amplification circuit SA, and send the switch signal to the switch amplification circuit SA. In the following solution, an example in which the second envelope signal ET2_DAC41 is used as the first drive signal DR1 is used for description. It can be understood that the first drive signal DR 1 is the switch signal of the switch amplification circuit SA obtained by converting the second envelope signal ET2_DAC41.

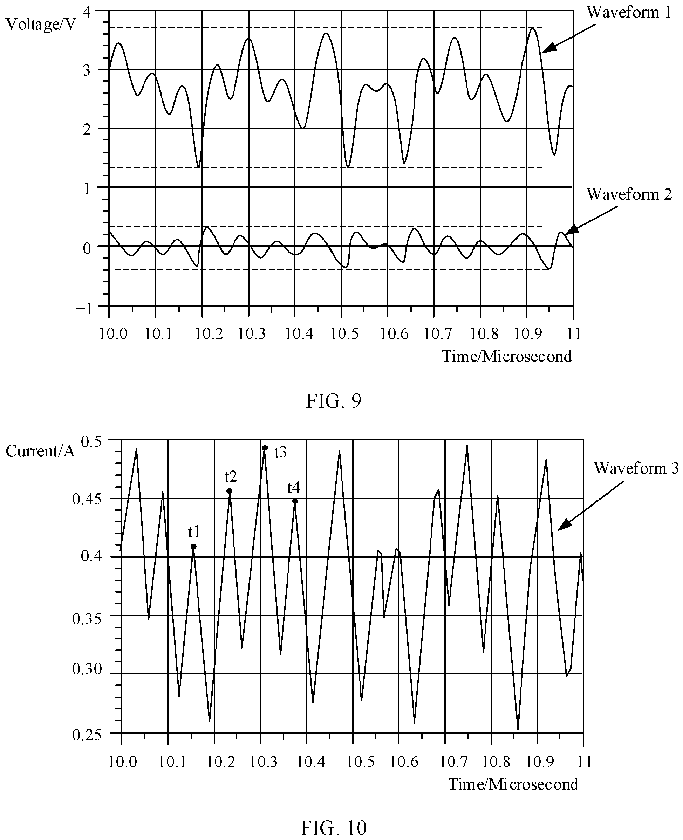

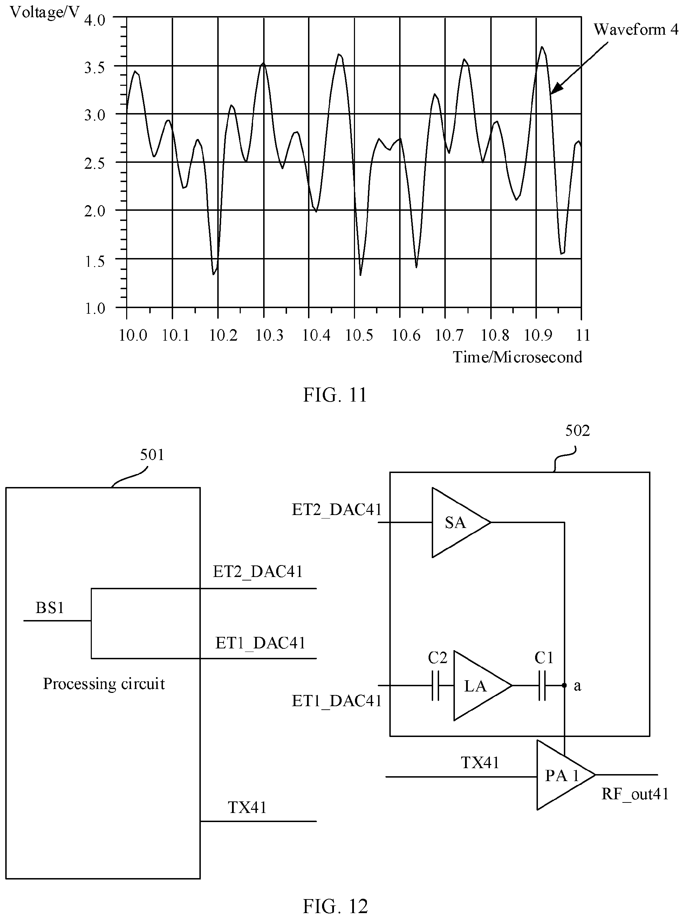

With reference to the wireless communication system shown in FIG. 7 and schematic diagrams of voltage (or current) waveforms of key nodes shown in FIG. 9, FIG. 10, and FIG. 11, a voltage output by the wireless communication system to the first node a (that is, the power supply end of the power amplifier PA) provided in an embodiment of this application is analyzed as follows: A waveform 1 in FIG. 9 is a waveform of the first power supply voltage at the output end of the LA (where a horizontal axis represents time in microseconds, and a vertical axis represents a voltage in volts V; and it can be learned that, in the waveform 1, a highest crest is about 3.7 V, a lowest trough is about 1.3 V, and a difference between the highest crest and the lowest trough reaches 2.4 V). The low frequency part and the direct current part in the first power supply voltage are filtered out through filtering performed by the first filter capacitor C1. In this case, the waveform of the first power supply voltage is shown as a waveform 2, and the waveform 2 represents an alternating current voltage that swings around 0 V (it can be learned that, in the waveform 2, a highest crest is about 0.3 V, a lowest trough is about - 0.4 V, and a difference between the highest crest and the lowest trough is 0.7 V). In this way, because the first filter capacitor C1 exists, the first filter capacitor C1 couples the output end of the LA to the output end of the switch amplification circuit SA, and a voltage swing amplitude (that is, the waveform 2) may be provided between an output voltage of the SA (that is, the second power supply voltage, for example, a waveform 3 in FIG. 10, where a horizontal axis represents time in microseconds, and a vertical axis represents a current in amperes A) and a power supply voltage of the PA (a waveform 4 shown in FIG. 11, where the waveform 2 and the waveform 3 are superposed at the first node a to obtain the waveform 4). In this way, a power supply voltage of the LA only needs to be equal to the voltage swing amplitude, but does not need to be equal to a voltage value of the highest crest in the waveform 1, so that the power supply voltage of the LA can be reduced, and a peak voltage of an envelope signal higher than the power supply voltage of the LA can be supported. Because a final power supply voltage of the PA 1 depends on superposition of the output voltage of the SA and a voltage swing amplitude output by the LA, with a lower supply voltage of the LA, a larger power output of the PA 1 can be supported, so that transmit efficiency of the PA 1 is improved. In addition, the first filter capacitor C1 can isolate the direct current part and the low frequency part in the first power supply voltage. Therefore, the LA with low efficiency only needs to amplify an envelope signal of a part of the first transmit signal BS1 (an envelope signal of a high frequency part, where for example, the first envelope signal ET1_DAC41 includes the envelope signal of the high frequency part in the first transmit signal), and an envelope signal of most of the first transmit signal (all the signal or a low frequency part and a direct current part, where for example, the second envelope signal ET_DAC42 includes an envelope signal of all the first transmit signal or the low frequency part and the direct current part in the first transmit signal) is amplified by the SA with high efficiency to generate the waveform 3. Finally, the waveform 2 and an output waveform (the waveform 3) of the SA are superposed at the first node a to obtain the waveform 4 (that is, a voltage at the power supply end of the power amplifier PA 1, as shown in FIG. 11, where a horizontal axis represents time in microseconds, and a vertical axis represents a voltage in volts V) to provide the power supply voltage for the power amplifier PA 1.

In addition, as shown in FIG. 8, when the first filter capacitor C1 is disposed at the input end of the LA, the first filter capacitor C1 may directly filter out the low frequency part and the direct current part in the first envelope signal ET1_DAC41. A waveform of the first envelope signal ET1_DAC41 is similar to the waveform 1. However, when the first envelope signal ET1_DAC41 is not amplified by the LA, an overall amplitude of the waveform of the first envelope signal ET1_DAC41 is smaller than that of the waveform 1. After the first filter capacitor C1 filters out the low frequency part and the direct current part in the first envelope signal ET1_DAC41, the waveform of the first envelope signal ET1_DAC41 is similar to the waveform 2, and an overall amplitude of the waveform of the first envelope signal ET1_DAC41 is smaller than that of the waveform 2. Compared with the solution shown in FIG. 7, because the first filter capacitor C1 is disposed at the input end of the LA, the low frequency part and the direct current part in the first envelope signal ET1_DAC41 are filtered out before the first envelope signal ET1_DAC41 is input to the LA. Therefore, the LA only needs to amplify the high frequency part in the first envelope signal ET1_DAC41. In addition, because the direct current part is removed, the power supply voltage of the LA can be effectively reduced, to achieve energy saving.

In another solution, with reference to FIG. 12, a second filter capacitor C2 may be disposed at the input end of the LA, and the first filter capacitor C1 may be disposed at the output end of the LA at the same time. Specifically, the first filter capacitor C1 is coupled to the output end of the LA, and the second filter capacitor C2 is coupled to the input end of the LA. The first filter capacitor C1 is configured to filter out the low frequency part and the direct current part in the first power supply voltage. The second filter capacitor C2 is configured to filter out the low frequency part and the direct current part in the first envelope signal ET1_DAC41. For functions of the first filter capacitor C1 and the second filter capacitor C2 in FIG. 12, refer to the descriptions of effect of disposing the first filter capacitor C1 at the input end or the output end of the LA in FIG. 7 and FIG. 8. Specifically, when the second filter capacitor C2 is disposed at the input end of the LA, the second filter capacitor C2 may directly filter out the low frequency part and the direct current part in the first envelope signal ET1_DAC41. The waveform of the first envelope signal ET1_DAC41 is similar to the waveform 1. However, when the first envelope signal ET1_DAC41 is not amplified by the LA, the overall amplitude of the waveform of the first envelope signal ET1_DAC41 is smaller than that of the waveform 1. After the second filter capacitor C2 filters out the low frequency part and the direct current part in the first envelope signal ET1_DAC41, the waveform of the first envelope signal ET1_DAC41 is similar to the waveform 2, and the overall amplitude of the waveform of the first envelope signal ET1_DAC41 is smaller than that of the waveform 2. Compared with the solution shown in FIG. 7, because the second filter capacitor C2 is disposed at the input end of the LA, the low frequency part and the direct current part in the first envelope signal ET1_DAC41 are filtered out before the first envelope signal ET1_DAC41 is input to the LA. Therefore, the LA only needs to amplify the high frequency part in the first envelope signal ET1_DAC41. In addition, because the direct current part is removed, the power supply voltage of the LA can be effectively reduced, to further achieve energy saving. In addition, a function of the first filter capacitor C1 in FIG. 12 is similar to that of the first filter capacitor C1 in FIG. 7. Details are not described herein again.

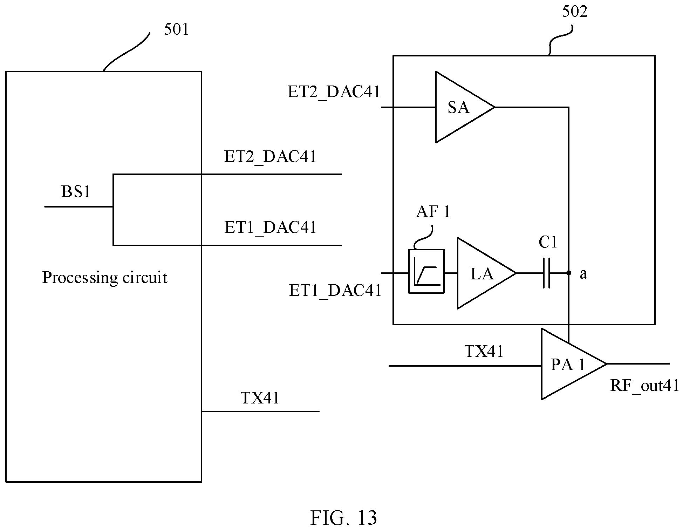

In another solution, with reference to FIG. 13, an analog high-pass filter AF 1 is further included. The first filter capacitor C1 is coupled to the output end of the linear amplification circuit LA, and the analog high-pass filter AF 1 is coupled to the input end of the linear amplification circuit LA. The first filter capacitor C1 is configured to filter out the low frequency part and the direct current part in the first power supply voltage. The analog high-pass filter AF 1 is configured to filter out the low frequency part and the direct current part in the first envelope signal ET1_DAC41. When the analog high-pass filter AF 1 is disposed at the input end of the LA, the analog high-pass filter AF 1 may directly filter out the low frequency part and the direct current part in the first envelope signal ET1 _DAC41. The waveform of the first envelope signal ET1_DAC41 is similar to the waveform 1. However, when the first envelope signal ET1_DAC41 is not amplified by the LA, the overall amplitude of the waveform of the first envelope signal ET1_DAC41 is smaller than that of the waveform 1. After the analog high-pass filter AF 1 filters out the low frequency part and the direct current part in the first envelope signal ET1_DAC41, the waveform of the first envelope signal ET1_DAC41 is similar to the waveform 2, and the overall amplitude of the waveform of the first envelope signal ET1_DAC41 is smaller than that of the waveform 2. Compared with the solution shown in FIG. 7, because the analog high-pass filter AF 1 is disposed at the input end of the LA, the low frequency part and the direct current part in the first envelope signal ET1_DAC41 are filtered out before the first envelope signal ET1_DAC41 is input to the LA. Therefore, the LA only needs to amplify the high frequency part in the first envelope signal ET1_DAC41. In addition, because the direct current part is removed, the power supply voltage of the LA can be effectively reduced, to further achieve energy saving. In addition, the function of the first filter capacitor C1 in FIG. 12 is similar to that of the first filter capacitor C1 in FIG. 7. Details are not described herein again.

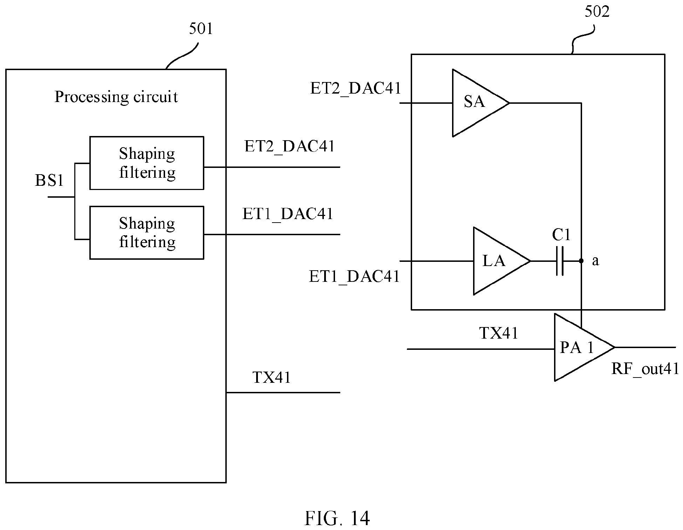

In another solution, as shown in FIG. 14, the processing circuit 501 is specifically configured to: perform shaping filtering on the first transmit signal BS1 to generate the first envelope signal ET1_DAC41; and perform shaping filtering on the first transmit signal BS1 to generate the second envelope signal ET2 _DAC41. A function of performing shaping filtering on the first transmit signal BS1 is to enable the signal to better match a subsequent hardware channel (for example, to enable an amplitude and a phase of the first envelope signal ET1_DAC41 to better match a hardware capability of the LA, and to enable an amplitude and a phase of the second envelope signal ET2_DAC41 to better match a hardware capability of the SA).

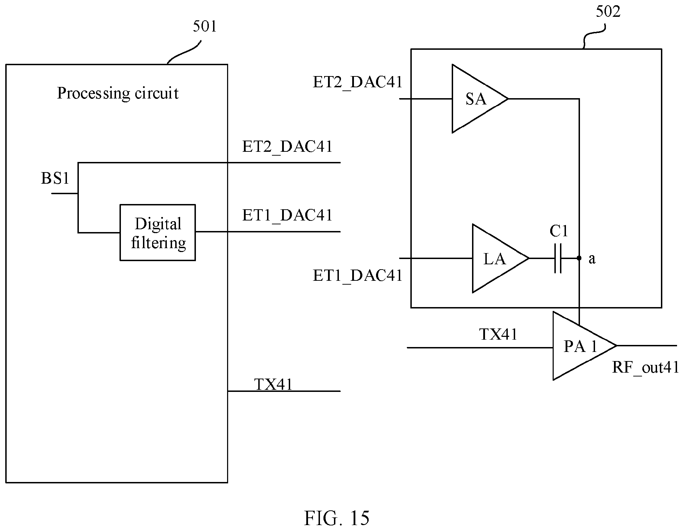

In another example, as shown in FIG. 15, the first filter capacitor C1 is coupled to the output end of the linear amplification circuit LA. The processing circuit 501 is configured to filter out the low frequency part and the direct current part in the first transmit signal BS1 to generate the first envelope signal ET1_DAC41. In the foregoing solutions provided in FIG. 8 and FIG. 13, the low frequency part and the direct current part in the first envelope signal ET1_DAC41 are filtered out in analog domain by using the second filter capacitor C2 or the analog high-pass filter AF 1. In an example provided in FIG. 15, the low frequency part and the direct current part in the first transmit signal BS1 may also be filtered out in digital domain by using a digital filtering function of the processing circuit 501, to generate the first envelope signal ET1_DAC41.

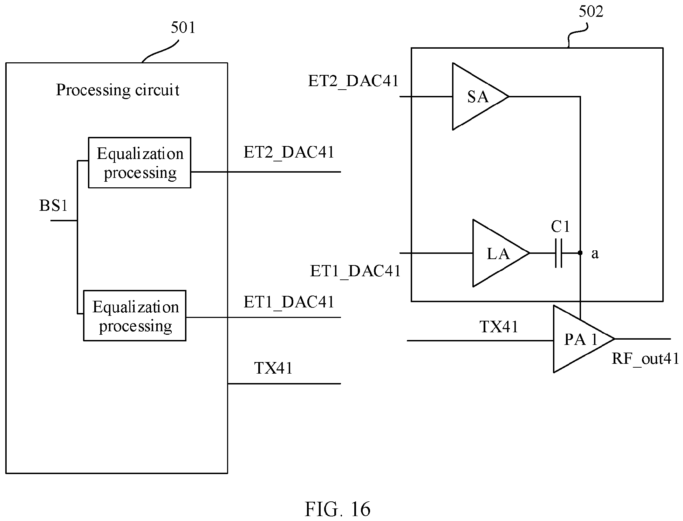

In another example, transmission paths of subsequent hardware channels of the first envelope signal ET1_DAC41 and the second envelope signal ET2 _DAC41 are different, where the first envelope signal ET1_DAC41 is input to the LA, and the second envelope signal ET2_DAC41 is input to the SA. Therefore, a difference in hardware causes a phase difference between signals at the output ends of the LA and the SA and an amplitude loss. Therefore, refer to FIG. 16. In a solution provided in an embodiment of this application, the processing circuit 501 may further perform equalization processing on the first transmit signal BS1. For example, the processing circuit 501 is further configured to perform amplitude and/or phase compensation on the first transmit signal BS1 to generate the first envelope signal ET1_DAC41; or is further configured to perform amplitude and/or phase compensation on the first transmit signal BS1 to generate the second envelope signal ET2 _DAC41. A specific value of the amplitude and/or phase compensation depends on a hardware parameter of the LA or the SA. A value of the amplitude and/or phase compensation corresponding to the first envelope signal ET1_DAC41 may be determined by using the hardware parameter of the LA or by detecting a voltage at the output end of the LA. A value of the amplitude and/or phase compensation corresponding to the second envelope signal ET2_DAC41 may be determined by using the hardware parameter of the SA or by detecting a voltage at the output end of the SA.

In addition, it should be noted that functions shown in FIG. 14, FIG. 15, and FIG. 16 mainly include that the processing circuit 501 performs processing, such as digital filtering, shaping filtering, and amplitude and/or phase compensation (phase alignment), on the first transmit signal BS1. Certainly, this embodiment of this application is not limited to the foregoing function processing performed on the first transmit signal BS1, and may further include function processing in another digital domain. The foregoing processing circuit 501 may have the functions shown in FIG. 14, FIG. 15, and FIG. 16, or may have one or more of the functions, and a sequence of the functions is not limited. For example, in one manner, the processing circuit 501 may be configured to perform shaping filtering on the first transmit signal BS1 after filtering out the low frequency part and the direct current part in the first transmit signal BS1, to generate the first envelope signal ET1_DAC41, and the processing circuit 501 may be configured to directly perform shaping filtering on the first transmit signal BS1 to generate the second envelope signal ET2_DAC41. In another manner, the processing circuit 501 may be configured to perform shaping filtering on the first transmit signal BS1 after performing amplitude and/or phase compensation on the first transmit signal BS1, to generate the first envelope signal ET1 DAC41, the processing circuit 501 may be configured to perform shaping filtering on the first transmit signal BS1 after performing amplitude and/or phase compensation on the first transmit signal BS1, to generate the second envelope signal ET2 DAC41, and so on.

In the wireless communication system provided in the foregoing solution, in addition to improving the EMT 502 used as a power supply circuit in the analog domain, in the digital domain, the processing circuit 501 further needs to be capable of separately generating, based on the first transmit signal BS1, the first envelope signal ET1_DAC41 provided to the LA and the first drive signal DR (which, for example, may be the second envelope signal ET2_DAC41) provided to the SA. In other words, the processing circuit 501 is also correspondingly improved.

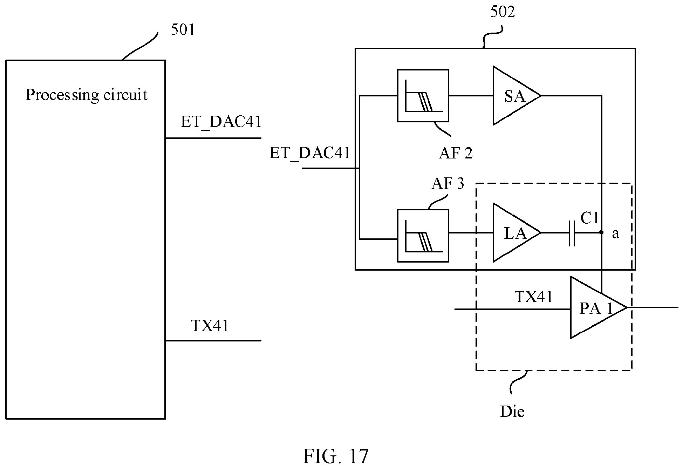

In another solution, to directly adapt to the processing circuit 40 provided in FIG. 4, that is, to be directly compatible with the processing circuit 40 provided in FIG. 4 without improving the processing circuit 40, refer to FIG. 17. A power supply circuit is provided, including: at least one first analog low-pass filter AF 2, at least one second analog low-pass filter AF 3, at least one linear amplification circuit LA, a switch amplification circuit SA, and at least one first filter capacitor C1. An output end of the linear amplification circuit LA, an output end of the switch amplification circuit SA, and a power supply end of a power amplifier PA 1 are coupled at a first node a. The first filter capacitor C1 is coupled to an input end of the linear amplification circuit LA or the output end of the linear amplification circuit LA.

The second analog low-pass filter AF3 is configured to filter out a high frequency part in a predetermined envelope signal ET_DAC41 received from a processing circuit 501, to generate a second envelope signal ET2 _DAC41. The first analog low-pass filter AF 2 is configured to perform delay adjustment on the predetermined envelope signal ET_DAC41 received from the processing circuit 501, to generate a first envelope signal ET1_DAC41. The predetermined envelope signal ET _DAC41 is generated by the processing circuit based on a first transmit signal BS1. The linear amplification circuit LA is configured to: receive the first envelope signal ET1_DAC41, and output a first power supply voltage to the first node a. The switch amplification circuit SA is configured to: receive the second envelope signal ET2_DAC41, and output a second power supply voltage to the first node a. The power amplifier PA 1 amplifies, based on the first power supply voltage and the second power supply voltage, a first radio frequency signal TX41 generated by the processing circuit 501 based on the first transmit signal BS1. The first analog low-pass filter AF 2, the second analog low-pass filter AF 3, the linear amplification circuit LA, the switch amplification circuit SA, and the first filter capacitor C1 form an EMT 502 of the PA 1. The first filter capacitor C1 is configured to: filter out a low frequency part and a direct current part in the first envelope signal ET1_DAC41, or filter out a low frequency part and a direct current part in the first power supply voltage.

Compared with an example provided in FIG. 7, in the EMT 502 provided in FIG. 17, for the predetermined envelope signal ET_DAC41 received from the processing circuit 501, one first analog low-pass filter AF 2 is added to an input end of the SA to perform low-pass filtering on an input predetermined envelope signal ET_DAC41 (filtering out a high frequency part in the predetermined envelope signal ET_DAC41) to extract a waveform input to the SA (that is, the second envelope signal ET2_DAC41). A bandwidth of the first analog low-pass filter AF 2 may be determined based on a switching frequency of the SA, for example, 1 MHz, 5 MHz, or 10 MHz. One second analog low-pass filter AF 3 is added to the input end of the SA to perform delay adjustment on the predetermined envelope signal ET_DAC41 to generate the first envelope signal ET1_DAC41, to implement delay difference adjustment of two signals on the SA and the LA and ensure phase alignment of voltages output by the SA and the LA. Therefore, the processing circuit 40 in FIG. 4 does not need to be changed, and the predetermined envelope signal ET_DAC41 may be directly and compatibly used to supply power to the power amplifier PA 1. In this solution, for a function and a purpose of another structure, refer to related descriptions in FIG. 7. Details are not described herein again. Similar to FIG. 7, the first filter capacitor C1 shown in FIG. 17 is disposed at the output end of the LA. Certainly, the first filter capacitor C1 may also be disposed at the input end of the LA as shown in FIG. 8. Alternatively, as shown in FIG. 12, a second filter capacitor C2 is disposed at the input end of the LA, and the first filter capacitor C1 is disposed at the output end of the LA. Alternatively, as shown in FIG. 13, an analog high-pass filter AF 1 is disposed at the input end of the LA, and the first filter capacitor C1 is disposed at the output end of the LA.

During actual application, FIG. 7 and FIG. 17 are used as examples. Each envelope modulator EMT includes one LA and one SA. The LA and the SA may be separately packaged or packaged together. However, in an embodiment of this application, the LA mainly processes the high frequency part in the first envelope signal ET_DAC41, and inductive reactance or capacitive reactance of a trace between the LA and the PA 1 causes degradation of a high frequency signal. Therefore, it is necessary to shorten a trace length between the LA and the PA as much as possible, to reduce the inductive reactance or the capacitive reactance of the trace. In some examples, a length of the trace between the linear amplification circuit LA and the power amplifier PA 1 is less than a length of a trace between the switch amplification circuit SA and the power amplifier PA 1. Alternatively, the linear amplification circuit LA and the power amplifier PA 1 are packaged on a same package substrate, or the linear amplification circuit LA and the power amplifier PA 1 are manufactured on a same die (a die shown in FIG. 7 and FIG. 17), to reduce the length of the trace between the switch amplification circuit SA and the power amplifier PA 1. In some examples, to better arrange the switch amplification circuit SA and the power amplifier PA 1 to reduce the length of the trace between the switch amplification circuit SA and the power amplifier PA 1, the linear amplification circuit LA and the switch amplification circuit SA may be manufactured on different dies.

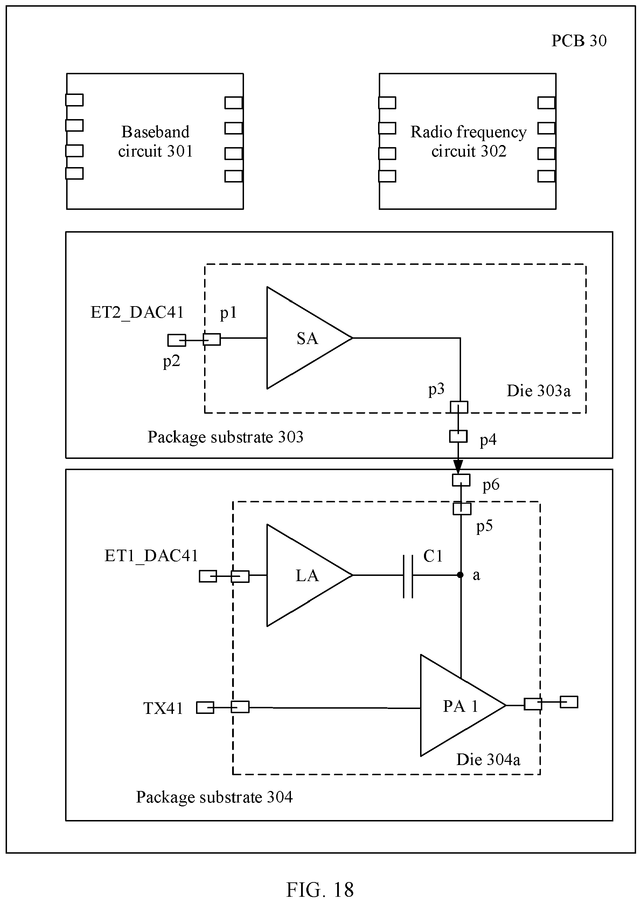

In some possible implementations, FIG. 18 is a schematic diagram of circuit packaging of a wireless communication system according to an embodiment of this application. In FIG. 18, the wireless communication system in FIG. 7 is used as an example for description. For clear display, line coupling in a package substrate 301, a package substrate 302, and a PCB 30 is omitted in FIG. 18, and only a part of a transmit link is shown. The wireless communication system includes: the PCB 30, a packaged baseband circuit 301, a packaged radio frequency circuit 302, a packaged die 303a, and a packaged die 304a. These devices are electrically coupled to the PCB 30 by using a pin (Pin). In an implementation, an SA may be independently manufactured on the die 303a and packaged on the package substrate 303. To reduce impact of a length of a trace between a linear amplification circuit LA and a power amplifier PA 1 on a high frequency part of a signal transmitted between the linear amplification circuit LA and the power amplifier PA 1, the LA and the PA 1 may be manufactured on the same die 304a by using a same chip process and packaged on the package substrate 304. An input end or an output end of the SA is electrically coupled (for example, directly connected) to a pad on the die 303a, and an input end or an output end of the LA is electrically coupled to a pad on the die 304a. For example, the input end of the SAis electrically coupled to a pad p1 on the die 303a, and the pad p1 on the die 303a is electrically coupled to a pad p2 on the package substrate 303 by using a wire W1 (for example, may be connected by using a gold wire through bonding) (certainly, the pads may alternatively be coupled in another manner such as using a solder ball). The output end of the SA is electrically coupled to a pad p3 on the die 303a, and the pad p3 on the die 303a is electrically coupled to a pad p4 on the package substrate 303 by using a wire W2. The output end of the LA is coupled at a first node a by using a C1, the first node a is electrically coupled to a pad p5 on the die 304a, and the pad p5 on the die 304a is electrically coupled to a pad p6 on the package substrate 304 by using a wire W3. The pad p4 on the package substrate 303 and the pad p6 on the package substrate 304 are soldered on the PCB 30, and are electrically coupled by using a trace on the PCB 30, so that the output end of the SA is coupled at the first node a. The foregoing describes only packaging manners of some devices in an embodiment of this application. For another structure such as packaging manners for a power supply end, an output end, and an input end of the PA and the input end of the LA, refer to the foregoing descriptions. In addition, in some examples, the LA and the PA 1 may be manufactured on different dies and packaged on a same package substrate. In other examples, the LA, the SA, and the PA 1 may alternatively be manufactured on a same die, or separately manufactured on different dies and packaged on a same package substrate.

The foregoing baseband circuit 301, radio frequency circuit 302, packaged die 303a, and packaged die 304a may form a chipset (chipset), to process to-be-transmitted data and then transmit the processed data by using an antenna circuit. The chipset is a group of integrated circuits that work together.

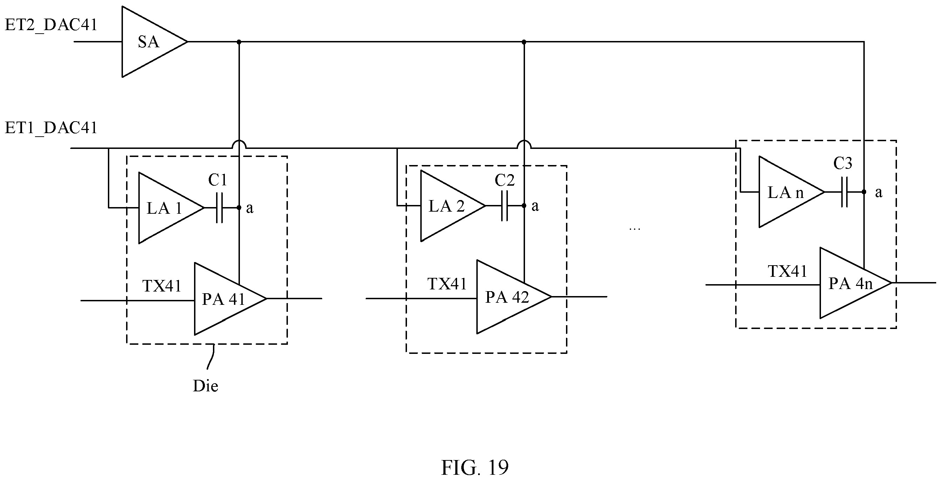

In an embodiment of this application, the foregoing wireless communication system may further support a beamforming (beamforming) architecture. In one beamforming architecture, when a processing circuit 501 transmits a same radio frequency signal TX41 on a plurality of channels, as shown in FIG. 19, each channel corresponds to one power amplifier (PA 41, PA42, ..., or PA 4n). In this case, to reduce hardware costs, a plurality of LAs (LA 1, LA 2, ..., and LA n) may share one SA. As shown in FIG. 19, the wireless communication system may include two or more linear amplification circuits LAs (LA 1, LA 2, ..., and LA n), two or more first filter capacitors (C1, C2, ..., and Cn), and two or more power amplifiers (PA41, PA42, ..., and PA4n). For example, the SA, the LA 1, and the C1 form an EMT 1 to supply power to the PA 41, the SA, the LA 2, and the C2 form an EMT 2 to supply power to the PA 42, and the SA, the LA n, and the Cn form an EMT n to supply power to the PA 4n. For a specific connection relationship of a device in each EMT, refer to descriptions in FIG. 7. Details are not described herein again. In this case, the processing circuit 501 separately outputs a first envelope signal ET1_DAC41 of a transmit signal BS1 corresponding to the radio frequency signal TX41 to input ends of the LA 1, the LA 2, ..., and the LA n, and the processing circuit 501 outputs a second envelope signal ET2_DAC41 of the transmit signal BS1 corresponding to the radio frequency signal TX41 to an input end of the SA. In this way, a same radio frequency signal is simultaneously transmitted on different power amplifiers.

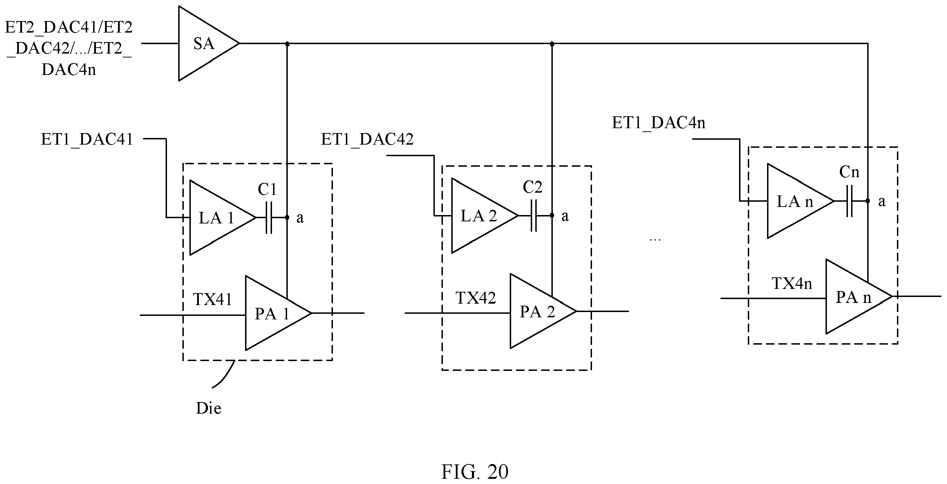

In an architecture such as MIMO that supports dual-channel or multi-channel transmission, the processing circuit 501 may provide radio frequency signals of a plurality of channels: a TX41, a TX42, ..., or a TX4n. Refer to FIG. 20. Each channel corresponds to one power amplifier (PA 41, PA 42, ..., or PA 4n). In this case, to reduce the hardware costs, the plurality of LAs (LA 1, LA 2, ..., and LA n) may share one SA. As shown in FIG. 19, the wireless communication system may include two or more linear amplification circuits LAs (LA 1, LA2, ..., and LA n), two or more first filter capacitors (C1, C2, ..., and Cn), and two or more power amplifiers (PA41, PA42, ..., and PA 4n). For example, the SA, the LA 1, and the C1 form the EMT 1 to supply power to the PA 41, the SA, the LA 2, and the C2 form the EMT 2 to supply power to the PA 42, and the SA, the LA n, and the Cn form the EMT n to supply power to the PA 4n. For the specific connection relationship of the device in each EMT, refer to descriptions in FIG. 7. Details are not described herein again. In this case, the processing circuit 501 may enable each PA by using an enable signal PA_EN of each PA. For example, when transmitting the radio frequency signal TX41, the processing circuit 501 outputs an enable signal PA41_EN to the PA 41. In a state in which the PA 41 is enabled, the processing circuit 501 outputs the first envelope signal ET_DAC41 of the transmit signal BS1 corresponding to the radio frequency signal TX41 to the input end of the LA 1, and the processing circuit 501 outputs a first drive signal (for example, the second envelope signal ET2_DAC41) of the transmit signal BS1 corresponding to the radio frequency signal TX41 to the input end of the SA. When transmitting a radio frequency signal TX42, the processing circuit 501 outputs an enable signal PA42_EN to the PA 42. In a state in which the PA 42 is enabled, the processing circuit 501 outputs a first envelope signal ET1_DAC42 of a transmit signal BS2 corresponding to the radio frequency signal TX42 to the input end of the LA 1, and the processing circuit 501 outputs a first drive signal (for example, a second envelope signal ET2_DAC42) of the transmit signal BS2 corresponding to the radio frequency signal TX42 to the input end of the SA. When transmitting a radio frequency signal TX43, the processing circuit 501 outputs an enable signal PA43_EN to the PA 43. In a state in which the PA 43 is enabled, the processing circuit 501 outputs a first envelope signal ET1_DAC43 of a transmit signal BS3 corresponding to the radio frequency signal TX43 to the input end of the LA 1, and the processing circuit 501 outputs a first envelope signal ET2_DAC43 of the transmit signal BS3 corresponding to the radio frequency signal TX43 to the input end of the SA. The rest can be deduced by analogy. In this way, the processing circuit may transmit a radio frequency signal of a corresponding channel on a power amplifier enabled by using the enable signal. In this way, different radio frequency signals may be transmitted on different power amplifiers in a time-sharing manner.

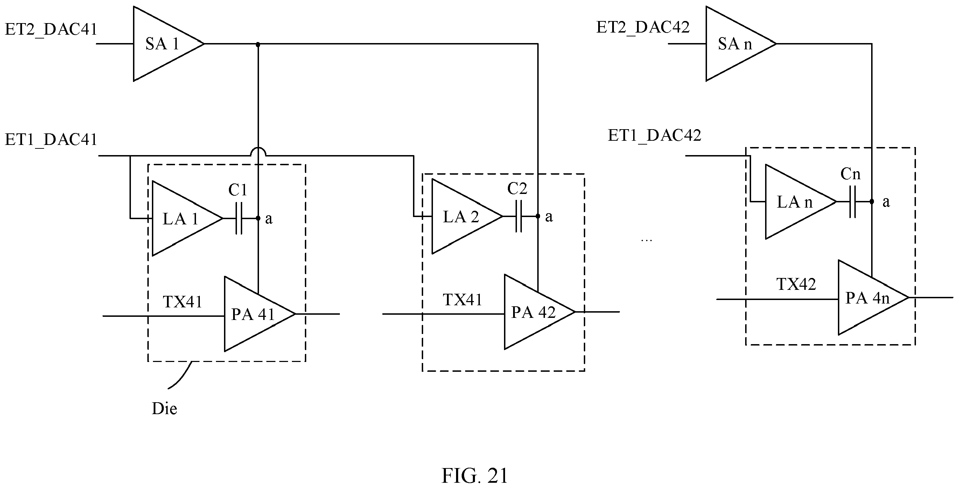

In addition, in a scenario of a plurality of transmit channels, for example, in an uplink multiple-input multiple-output (multiple-input multiple-out, MIMO) or uplink carrier aggregation (carrier aggregation, CA) scenario, the processing circuit 501 may provide radio frequency signals of a plurality of channels, for example, the TX41 or the TX42. The processing circuit 501 may transmit a same radio frequency signal on some channels, and transmit different radio frequency signals on the other channels. Refer to FIG. 21. Each channel corresponds to one power amplifier (PA 41, PA 42, ..., or PA 4n). Channels in which the PA 41 and the PA 42 are located transmit a same radio frequency signal TX1, and a channel in which the PA 4n is located transmit another radio frequency signal TX2. In this case, to reduce the hardware costs, the plurality of LAs (LA 1 and LA 2) may share one SA 1, and the LA n independently uses one SA n. Therefore, in this scenario, the wireless communication system includes a plurality of SAs. As shown in FIG. 21, the wireless communication system may include two or more linear amplification circuits LAs (LA 1, LA 2, ..., and LA n), two or more first filter capacitors (C1, C2, ..., and Cn), two or more power amplifiers (PA 41, PA 42, ..., and PA 4n), and two switch amplification circuits SAs (SA 1 and SA 2). For example, the SA 1, the LA 1, and the C1 form the EMT 1 to supply power to the PA 41, the SA 1, the LA 2, and the C2 form the EMT 2 to supply power to the PA 42, and the SA 2, the LA n, and the Cn form the EMT n to supply power to the PA 4n. For the specific connection relationship of the device in each EMT, refer to descriptions in FIG. 7. Details are not described herein again. In this case, the processing circuit 501 separately outputs the first envelope signal ET1_DAC41 of the transmit signal BS1 corresponding to the radio frequency signal TX41 to the input ends of the LA 1 and the LA 2, and the processing circuit 501 outputs the second envelope signal ET2_DAC41 of the transmit signal BS1 corresponding to the radio frequency signal TX41 to an input end of the SA 1. The processing circuit 501 outputs the first envelope signal ET1_DAC42 of the transmit signal BS2 corresponding to the radio frequency signal TX42 to the input end of the LA n, and the processing circuit 501 outputs the second envelope signal ET2_DAC42 of the transmit signal BS2 corresponding to the radio frequency signal TX42 to an input end of the SA2. The rest can be deduced by analogy.

In addition, as shown in FIG. 19, FIG. 20, and FIG. 21, in each EMT, the LA and the PA may be manufactured on a same die by using a same chip manufacturing process or packaged on a same package substrate, to reduce the length of the trace between the LA and the PA.

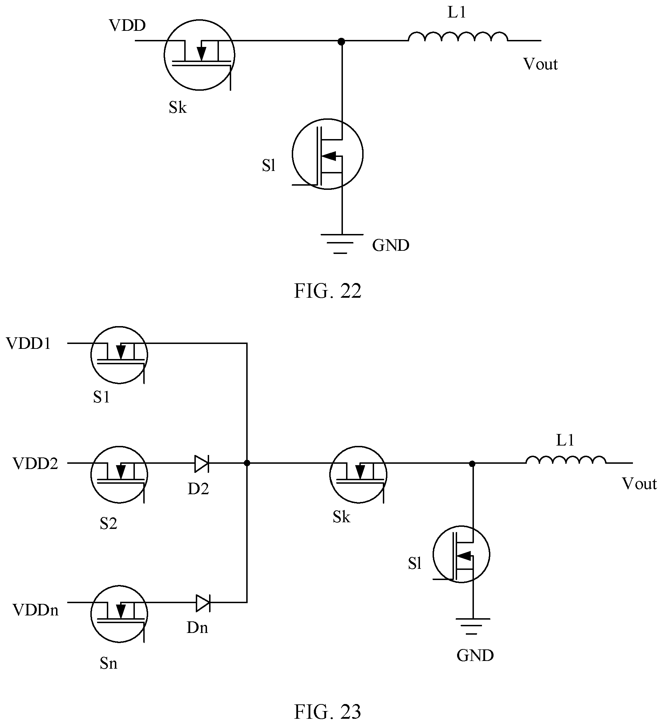

As shown in FIG. 22, a typical circuit structure of an SA is provided, where the SA includes a transistor Sk, a transistor Sl, and an inductor L1. A first electrode of the transistor Sk is coupled to a power supply end VDD of the SA. A second electrode of the transistor Sk is coupled to a first electrode of the transistor Sl. A second electrode of the transistor Sl is coupled to a ground end GND. The inductor L1 is coupled between the second electrode of the transistor Sk and an output end Vout of the SA. As described above, a processing circuit 501 may also convert a second envelope signal ET2_DAC41 to a switch signal of the switch amplification circuit SA, and send the switch signal to the switch amplification circuit SA. The switch signal of the switch amplification circuit SA includes a first switch signal input to a control end of the transistor Sk and a second switch signal input to the transistor Sl. In addition, when the SA includes a control chip, the control chip may also convert the second envelope signal ET2_DAC41 to the switch signal of the switch amplification circuit SA. Under control of the first switch signal and the second switch signal, the transistor Sk and the transistor Sl are in a switching state of being on or off, and a voltage of the power supply end VDD is converted to a second power supply voltage and is output to the output end Vout. The first electrode of the transistor (Sk or Sl) in FIG. 22 may be a source (source, S), and the second electrode of the transistor (Sk or Sl) may be a drain (drain, D). In an embodiment, the second electrode of the transistor (Sk or Sl) may be the source (source, S), and the first electrode of the transistor (Sk or Sl) may be the drain (drain, D). The control end of the transistor is a gate (gate, G). In the following solution, a structure of a transistor is similar to that of the Sk or the Sl. Details are not described again.

In the solution described in FIG. 22, because the SA has only one power supply end VDD, and has only one switch circuit formed by the transistor Sk and the transistor Sl, only one fixed power supply voltage can be provided. When the power supply voltage is excessively high or low, an overcharging phenomenon may exist, and consequently a maximum value or a minimum value of an output voltage of the SA is limited. For example, when the power supply voltage is excessively low, a voltage lower than that at t1 in FIG. 10 may not be provided, or when the power supply voltage is excessively high, a voltage higher than that at t3 may not be provided. In addition, because only one fixed power supply voltage can be provided, a phase of the output second power supply voltage is limited by switching frequencies of Sk and Sl. For example, because in an embodiment of this application, the SA is used to process most of the first transmit signal (all the signal or a low frequency part and a direct current part), when a second power supply voltage with a higher frequency is required, for example, when a positive crest voltage needs to be provided between t2 and t3 or between t3 and t4 in FIG. 10, a capability of the SA provided in FIG. 22 is limited. Therefore, the SA provided in an embodiment of this application may be a multi-voltage and/or multi-phase switch amplification circuit.

To avoid a limitation on the maximum value or the minimum value of the output voltage of the SA, a multi-voltage SA is provided. Refer to FIG. 23. Based on FIG. 22, a plurality of transistors (S1, S2, ..., and Sn) are coupled to the first electrode of the transistor Sk. A first electrode of a transistor S1 is coupled to a first power supply end VDD1, and a second electrode of the transistor S1 is coupled to the first electrode of the transistor Sk. A first electrode of a transistor S2 is coupled to a second power supply end VDD2, and a second electrode of the transistor S2 is coupled to the first electrode of the transistor Sk. A first electrode of a transistor Sn is coupled to an n^{th} power supply end VDDn, and a second electrode of the transistor Sn is coupled to the first electrode of the transistor Sk. Voltages of different voltage values are input from the first power supply end VDD1, the second power supply end VDD2, ..., and the n^{th} power supply end VDDn. For example, an input voltage value of the first power supply end VDD1 is VDD, an input voltage value of the second power supply end VDD2 is VDD/m, and an input voltage value of the n^{th} power supply end VDDn is VDD/n. In this solution, the switch signal of the switch amplification circuit SA includes the switch signal input to the control end of the transistor Sk, the switch signal input to the transistor Sl, and switch signals input to the transistors (S1, S2, ..., and Sn). For example, because the input voltage value VDD of the first power supply end VDD1 is a high voltage, when the S1 is turned on by using the switch signal, the transistors Sk and Sl may be simultaneously controlled to output a high voltage to the output end Vout of the SA, for example, a voltage at t3 in FIG. 10. Because the input voltage value VDD/m of the second power supply end VDD2 is a low voltage (relative to the VDD), when the S2 is turned on by using the switch signal, the transistors Sk and Sl may be simultaneously controlled to output a low voltage to the output end Vout of the SA, for example, a voltage at t2 in FIG. 10. In addition, for example, to prevent a voltage of the VDD 1 from flowing back to the VDD2 or the VDDn when the S1 is turned on, a unidirectional diode may be coupled between the S2 (Sn) and the Sk. For example, the second electrode of the S2 may be coupled to an anode of a diode D2, and the first electrode of the Sk may be coupled to a cathode of a diode D2. The second electrode of the Sn may be coupled to an anode of a diode Dn, and the first electrode of the Sk may be coupled to a cathode of a diode Dn.

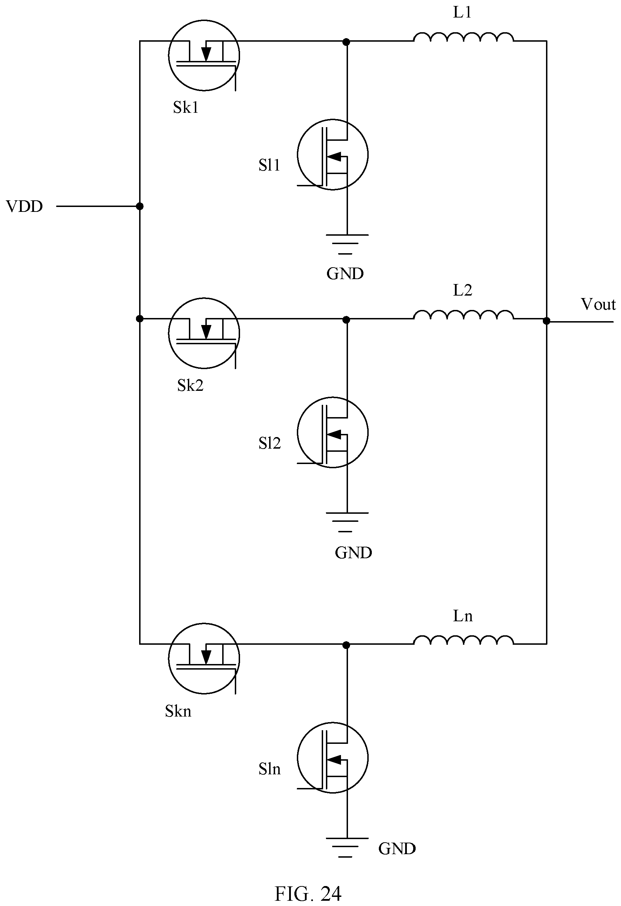

In addition, when a second power supply voltage with a higher frequency is required, the SA may be a multi-phase switch amplification circuit shown in FIG. 24. The multi-phase switch amplification circuit may include a plurality of switch amplification branches connected in parallel between the power supply end VDD and the output end Vout. A structure of each switch amplification branch is shown in FIG. 22. Specifically, a first switch amplification branch includes a transistor Sk1, a transistor Sl1, and an inductor L1. A second switch amplification branch includes a transistor Sk2, a transistor Sl2, and an inductor L2. An n^{th} switch amplification branch includes a transistor Skn, a transistor Sln, and an inductor Ln. For a connection relationship of the transistor and the inductor in each amplification branch, refer to a connection manner of the transistor and the inductor in FIG. 22. Details are not described herein again. In this solution, the switch signal of the switch amplification circuit SA includes switch signals input to control ends of the transistors Sk1, Sk2, ..., and Skn and the transistors Sl1, Sl2, ..., and Sln. For example, the transistors Sk1 and Sl1 in the first switch amplification branch may be controlled to output voltages at t1 and t3 in FIG. 10 to the output end Vout of the SA. The transistors Sk2 and Sl2 in the second switch amplification branch are controlled to output voltages at t2 and t4 in FIG. 10 to the output end Vout of the SA, so that compared with a second power supply voltage at the output end of the SA, a frequency of a voltage output by each switch amplification branch is low, and the SA formed by the plurality of switch amplification branches may output a voltage with a higher frequency. It should be noted that a switch signal output to each switch amplification branch needs to be controlled, so that phases of voltages output by the switch amplification branches are different.

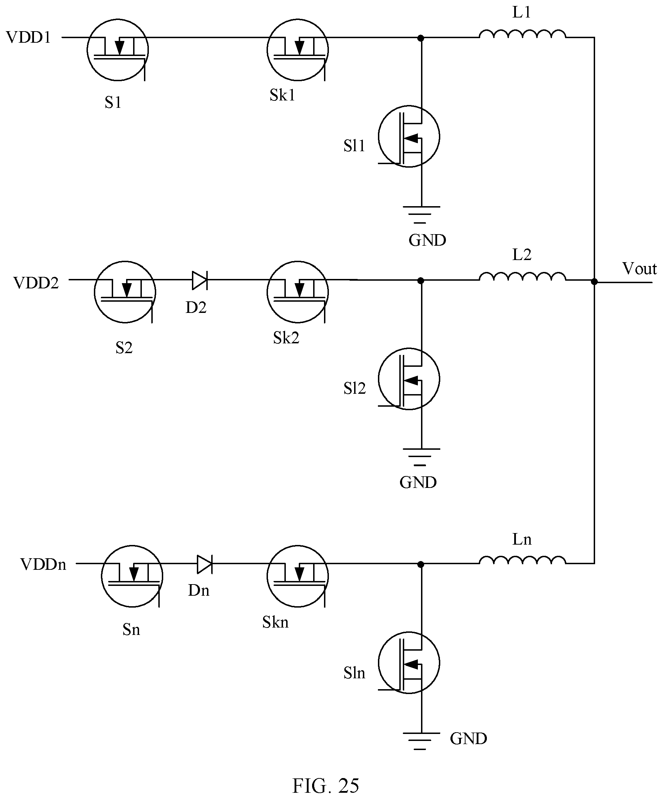

In addition, in another solution, refer to FIG. 25. A multi-phase and multi-voltage switch amplification circuit may be further provided. FIG. 25 is a combination of the solutions provided in FIG. 23 and FIG. 24. The multi-phase switch amplification circuit may include a plurality of switch amplification branches connected in parallel between the power supply end VDD and the output end Vout. A structure of each switch amplification branch is shown in FIG. 25. Specifically, a first switch amplification branch includes a transistor Sk1, a transistor Sl1, and an inductor L1. A second switch amplification branch includes a transistor Sk2, a transistor Sl2, and an inductor L2. An n^{th} switch amplification branch includes a transistor Skn, a transistor Sln, and an inductor Ln. For a connection relationship of the transistor and the inductor in each amplification branch, refer to the connection manner of the transistor and the inductor in FIG. 22. Details are not described herein again. In addition, a first electrode of the transistor Sk1 is coupled to a transistor S1. A first electrode of the transistor S1 is coupled to a first power supply end VDD1, and a second electrode of the transistor S1 is coupled to the first electrode of the transistor Sk1. A first electrode of a transistor S2 is coupled to a second power supply end VDD2, and a second electrode of the transistor S2 is coupled to a first electrode of the transistor Sk2. A first electrode of a transistor Sn is coupled to an n^{th} power supply end VDDn, and a second electrode of the transistor Sn is coupled to a first electrode of the transistor Skn. Voltages of different voltage values are input from the first power supply end VDD1, the second power supply end VDD2, ..., and the n^{th} power supply end VDDn. For example, an input voltage value of the first power supply end VDD1 is VDD, an input voltage value of the second power supply end VDD2 is VDD/m, and an input voltage value of the n^{th} power supply end VDDn is VDD/n. In this solution, the switch signal of the switch amplification circuit SAincludes switch signals input to control ends of the transistors Sk1, Sk2, ..., and Skn and transistors Sl1, Sl2, ..., and Sln, and switch signals input to the transistors (S1, S2, ..., and Sn). For a specific working principle, refer to the foregoing descriptions for the SA in FIG. 23 and FIG. 24. A difference lies in that this solution can simultaneously avoid a limitation on a maximum value or a minimum value of an output voltage of the SA, and can provide a second power supply voltage with a higher frequency. Therefore, a to-be-tracked signal can be better adapted. For example, flexibility of generating the switch signal of the switch amplification circuit SA based on a signal feature (a bandwidth and a peak-to-average power ratio (peak-to-average power ratio, PAPR)) of a second envelope signal of a first transmit signal can be improved, to improve overall efficiency of an EMT. Similarly, for example, to prevent a voltage of the VDD1 from flowing back to the VDD2 or the VDDn when the S1 is turned on, a unidirectional diode may be coupled between the S2 (Sn) and the Sk2 (Skn). For example, the second electrode of the S2 may be coupled to an anode of a diode D2, and the first electrode of the Sk2 may be coupled to a cathode of the diode D2. The second electrode of the Sn may be coupled to an anode of a diode Dn, and the first electrode of the Skn may be coupled to a cathode of the diode Dn.

In the foregoing embodiments, the description of each embodiment has respective focuses. For a part that is not described in detail in an embodiment, refer to related descriptions in other embodiments.

Although this application is described with reference to specific features and embodiments thereof, it is clear that various modifications and combinations may be made to them without departing from the scope of this application. Correspondingly, this specification and accompanying drawings are merely example descriptions of this application defined by the appended claims, and are considered as any of or all modifications, variations, combinations, or equivalents that cover the scope of this application. Obviously, a person skilled in the art can make various modifications and variations to this application without departing from the scope of this application. In this way, this application is intended to cover these modifications and variations of this application provided that they fall within the scope of the claims of this application and their equivalent technologies.

## Claims

1. A wireless communication system, comprising: a processing circuit, at least one linear amplification circuit, a switch amplification circuit, at least one first filter capacitor, and at least one power amplifier, wherein an output end of the switch amplification circuit, an output end of the linear amplification circuit, and a power supply end of the power amplifier are coupled at a first node, and the first filter capacitor is coupled to an input end of the linear amplification circuit or the output end of the linear amplification circuit;
the processing circuit is configured to: output a first radio frequency signal of a first transmit signal, and output a first envelope signal and a first drive signal that are of the first transmit signal, wherein the first drive signal comprises a switch signal of the switch amplification circuit or a second envelope signal, and the switch signal of the switch amplification circuit is generated by the processing circuit based on the second envelope signal;
the linear amplification circuit is configured to: receive the first envelope signal, and output a first power supply voltage to the first node;
the switch amplification circuit is configured to: receive the first drive signal, and output a second power supply voltage to the first node; and
the power amplifier is configured to amplify the first radio frequency signal based on the first power supply voltage and the second power supply voltage.

2. The wireless communication system according to claim 1, wherein
the first envelope signal comprises an envelope signal of a high frequency part in the first transmit signal; and/or
the second envelope signal comprises an envelope signal of a low frequency part and a direct current part in the first transmit signal.

3. The wireless communication system according to claim 1, wherein a highest frequency of the first envelope signal is greater than a highest frequency of the second envelope signal; and/or
a lowest frequency of the first envelope signal is greater than a lowest frequency of the second envelope signal.

4. The wireless communication system according to claim 1, further comprising a second filter capacitor, wherein the first filter capacitor is coupled to the output end of the linear amplification circuit, and the second filter capacitor is coupled to the input end of the linear amplification circuit.

5. The wireless communication system according to claim 1, further comprising an analog high-pass filter, wherein the first filter capacitor is coupled to the output end of the linear amplification circuit, and the analog high-pass filter is coupled to the input end of the linear amplification circuit.

6. The wireless communication system according to claim 1, wherein the processing circuit is further configured to: perform shaping filtering on the first transmit signal to generate the first envelope signal; and perform shaping filtering on the first transmit signal to generate the second envelope signal.

7. The wireless communication system according to claim 1, wherein the first filter capacitor is coupled to the output end of the linear amplification circuit; and
the processing circuit is configured to filter out a low frequency part and a direct current part in the first transmit signal to generate the first envelope signal.

8. The wireless communication system according to claim 1, wherein the processing circuit is further configured to perform amplitude and/or phase compensation on the first transmit signal to generate the first envelope signal, or is further configured to perform amplitude and/or phase compensation on the first transmit signal to generate the second envelope signal.

9. The wireless communication system according to any one of claims 1 to 8, wherein
a length of a trace between the linear amplification circuit and the power amplifier is less than a length of a trace between the switch amplification circuit and the power amplifier.

10. The wireless communication system according to any one of claims 1 to 8, wherein
the linear amplification circuit and the power amplifier are packaged on a same package substrate, or the linear amplification circuit and the power amplifier are manufactured on a same die.

11. The wireless communication system according to any one of claims 1 to 8, wherein the linear amplification circuit and the switch amplification circuit are manufactured on different dies.

12. The wireless communication system according to any one of claims 1 to 8, wherein the switch amplification circuit comprises a multi-phase and/or multi-voltage switch amplification circuit.

13. The wireless communication system according to any one of claims 1 to 8, wherein
at least one linear amplifier comprises a first linear amplifier and a second linear amplifier;
the at least one power amplifier comprises a first power amplifier and a second power amplifier;
the at least one first filter capacitor comprises a third filter capacitor and a fourth filter capacitor;
the output end of the switch amplification circuit, an output end of the first linear amplification circuit, and a power supply end of the first power amplifier are coupled at the first node, and the third filter capacitor is coupled to an input end of the first linear amplification circuit or the output end of the first linear amplification circuit;
the output end of the switch amplification circuit, an output end of the second linear amplification circuit, and a power supply end of the second power amplifier are coupled at a second node, and the fourth filter capacitor is coupled to an input end of the second linear amplification circuit or the output end of the second linear amplification circuit;
the first linear amplification circuit is configured to: receive the first envelope signal, and output the first power supply voltage to the first node; and
the second linear amplification circuit is configured to: receive the first envelope signal, and output a third power supply voltage to the second node.

14. The wireless communication system according to any one of claims 1 to 8, wherein at least one linear amplifier comprises a first linear amplifier and a second linear amplifier;
the at least one power amplifier comprises a first power amplifier and a second power amplifier;
the at least one first filter capacitor comprises a third filter capacitor and a fourth filter capacitor;
the output end of the switch amplification circuit, an output end of the first linear amplification circuit, and a power supply end of the first power amplifier are coupled at the first node, and the third filter capacitor is coupled to an input end of the first linear amplification circuit or the output end of the first linear amplification circuit;
the output end of the switch amplification circuit, an output end of the second linear amplification circuit, and a power supply end of the second power amplifier are coupled at a second node, and the fourth filter capacitor is coupled to an input end of the second linear amplification circuit or the output end of the second linear amplification circuit; and
when the first power amplifier is enabled by using an enable signal, the first linear amplification circuit is configured to: receive the first envelope signal, and output the first power supply voltage to the first node; or
when the second power amplifier is enabled by using an enable signal, the second linear amplification circuit is configured to: receive the first envelope signal, and output a third power supply voltage to the second node.

15. A power supply circuit, comprising: at least one linear amplification circuit, a switch amplification circuit, and at least one first filter capacitor, wherein
an output end of the linear amplification circuit and an output end of the switch amplification circuit are coupled at a first node, a power supply end of a power amplifier is coupled at the first node, and the first filter capacitor is coupled to an input end of the linear amplification circuit or the output end of the linear amplification circuit;
the linear amplification circuit is configured to: receive a first envelope signal sent by a processing circuit, and output a first power supply voltage to the first node;
the switch amplification circuit is configured to: receive a first drive signal sent by the processing circuit, and output a second power supply voltage to the first node, wherein the first envelope signal and the first drive signal are generated by the processing circuit based on a first transmit signal, the first drive signal comprises a switch signal of the switch amplification circuit or a second envelope signal, and the switch signal of the switch amplification circuit is generated by the processing circuit based on the second envelope signal; and
the power amplifier amplifies, based on the first power supply voltage and the second power supply voltage, a first radio frequency signal generated by the processing circuit based on the first transmit signal.

16. The power supply circuit according to claim 15, wherein
the first envelope signal comprises an envelope signal of a high frequency part in the first transmit signal; and/or
the second envelope signal comprises an envelope signal of a low frequency part and a direct current part in the first transmit signal.

17. The power supply circuit according to claim 15, further comprising a second filter capacitor, wherein the first filter capacitor is coupled to the output end of the linear amplification circuit, and the second filter capacitor is coupled to the input end of the linear amplification circuit.

18. The power supply circuit according to claim 15, further comprising an analog high-pass filter, wherein the first filter capacitor is coupled to the output end of the linear amplification circuit, and the analog high-pass filter is coupled to the input end of the linear amplification circuit.

19. The power supply circuit according to any one of claims 15 to 18, wherein
a length of a trace between the linear amplification circuit and the power amplifier is less than a length of a trace between the switch amplification circuit and the power amplifier.

20. The power supply circuit according to any one of claims 15 to 18, wherein
the linear amplification circuit and the power amplifier are packaged on a same package substrate, or the linear amplification circuit and the power amplifier are manufactured on a same die.

21. The power supply circuit according to any one of claims 15 to 18, wherein the linear amplification circuit and the switch amplification circuit are manufactured on different dies.

22. The power supply circuit according to any one of claims 15 to 18, wherein the switch amplification circuit comprises a multi-phase and/or multi-voltage switch amplification circuit.

23. A power supply circuit, comprising: at least one first analog low-pass filter, at least one second analog low-pass filter, at least one linear amplification circuit, a switch amplification circuit, and at least one first filter capacitor, wherein an output end of the linear amplification circuit and an output end of the switch amplification circuit are coupled at a first node, a power supply end of a power amplifier is coupled at the first node, and the first filter capacitor is coupled to an input end of the linear amplification circuit or the output end of the linear amplification circuit;
the second analog low-pass filter is configured to filter out a high frequency part in a predetermined envelope signal received from a processing circuit, to generate a first envelope signal;
the first analog low-pass filter is configured to perform delay adjustment on the predetermined envelope signal received from the processing circuit, to generate a second envelope signal;
the linear amplification circuit is configured to: receive the first envelope signal, and output a first power supply voltage to the first node;
the switch amplification circuit is configured to: receive the second envelope signal, and output a second power supply voltage to the first node, wherein the predetermined envelope signal is generated by the processing circuit based on a first transmit signal; and
the power amplifier amplifies, based on the first power supply voltage and the second power supply voltage, a first radio frequency signal generated by the processing circuit based on the first transmit signal.

24. The power supply circuit according to claim 23, further comprising a second filter capacitor, wherein the first filter capacitor is coupled to the output end of the linear amplification circuit, and the second filter capacitor is coupled to the input end of the linear amplification circuit.

25. The power supply circuit according to claim 23, wherein
the second analog low-pass filter is further configured to filter out a low frequency part and a direct current part in the first envelope signal.

26. The power supply circuit according to any one of claims 23 to 25, wherein
a length of a trace between the linear amplification circuit and the power amplifier is less than a length of a trace between the switch amplification circuit and the power amplifier.

27. The power supply circuit according to any one of claims 23 to 25, wherein
the linear amplification circuit and the power amplifier are packaged on a same package substrate, or the linear amplification circuit and the power amplifier are manufactured on a same die.

28. The power supply circuit according to any one of claims 23 to 25, wherein the linear amplification circuit and the switch amplification circuit are manufactured on different dies.

29. The power supply circuit according to any one of claims 23 to 25, wherein the switch amplification circuit comprises a multi-phase and/or multi-voltage switch amplification circuit.

30. A signal generation method, comprising:
outputting a first envelope signal of a first transmit signal; and
outputting a first drive signal of the first transmit signal, wherein the first drive signal comprises a switch signal of a switch amplification circuit or a second envelope signal; the switch signal of the switch amplification circuit is generated by a processing circuit based on the second envelope signal; and
the first envelope signal comprises an envelope signal of a high frequency part in the first transmit signal, and/or the second envelope signal comprises an envelope signal of a low frequency part and a direct current part in the first transmit signal.

31. The signal generation method according to claim 30, wherein the outputting a first envelope signal of a first transmit signal comprises: performing shaping filtering on the first transmit signal to generate the first envelope signal; and
the outputting a first drive signal of the first transmit signal comprises: performing shaping filtering on the first transmit signal to generate the first drive signal.

32. The signal generation method according to claim 30, wherein the outputting a first envelope signal of a first transmit signal comprises: filtering out the low frequency part and the direct current part in the first transmit signal to generate the first envelope signal.

33. The signal generation method according to claim 30, wherein the outputting a first envelope signal of a first transmit signal comprises: performing amplitude and/or phase compensation on the first transmit signal to generate the first envelope signal; and
the outputting a first drive signal of the first transmit signal comprises: performing amplitude and/or phase compensation on the first transmit signal to generate the first drive signal.

34. A processing circuit, wherein the processing circuit is configured to implement the signal generation method according to any one of claims 30 to 33.
